# FASCICULE DE BREVET EUROPEEN

(11) **EP 1 833 090 B1**
(45) Date de publication et mention de la délivrance du brevet: **03.04.2013**
(21) Numéro de dépôt: 07103731.1
(22) Date de dépôt: 08.03.2007
(51) Int. Cl.: H01L 27/11

(54) **Cellules mémoire en technologie CMOS double-grille dotée de transistors à deux grilles independantes**
Speicherzellen der CMOS-Technologie mit Doppel-Gate, die mit Transistoren mit zwei unabhängigen Gates ausgestattet sind
Memory cells in double-gate CMOS technology fitted with independent double-gate transistors

(30) Priorité: 10.03.2006 FR 0650824
(43) Date de publication de la demande: 12.09.2007
(73) Titulaire: Commissariat à l'Énergie Atomique et aux Énergies Alternatives, 75015 Paris (FR)
(72) Inventeur: Thomas, Olivier, 38420 Revel (FR); Belleville, Marc, 38120 Saint-Egreve (FR)
(74) Mandataire: Ahner, Philippe

(56) Documents cités:
- US-A1- 2005 199 964
- KIYOSHI TAKEUCHI ET AL: "A Study of the Threshold Voltage Variation for Ultra-Small Bulk and SOI CMOS" IEEE TRANSACTIONS ON ELECTRON DEVICES, IEEE SERVICE CENTER, PISACATAWAY, NJ, US, vol. 48, no. 9, septembre 2001 (2001-09), XP011017796 ISSN: 0018-9383
- ANANTHAN H ET AL: "FinFET SRAM-device and circuit design considerations" QUALITY ELECTRONIC DESIGN, 2004. PROCEEDINGS. 5TH INTERNATIONAL SYMPOSIUM ON SAN JOSE, CALIFORNIA 22-24 MARCH 2004, PISCATAWAY, NJ, USA,IEEE, 22 mars 2004 (2004-03-22), pages 511-516, XP010695543 ISBN: 0-7695-2093-6
- MAEGAWA S ET AL: "A 0.4 MUM GATE-ALL-AROUND TFT (GAT) USING A DUMMY NITRIDE PATTERN FOR HIGH-DENSITY MEMORIES" JAPANESE JOURNAL OF APPLIED PHYSICS, JAPAN SOCIETY OF APPLIED PHYSICS, TOKYO, JP, vol. 34, no. 2B, PART 1, 1 février 1995 (1995-02-01), pages 895-899, XP000599414 ISSN: 0021-4922

## Description

### DOMAINE TECHNIQUE

L'invention se rapporte au domaine des mémoires à accès aléatoires RAM (RAM pour « random access memory »), et concerne en particulier une structure de cellule mémoire statique à accès aléatoire développée en technologie double-grille et dotée de transistors comportant deux grilles commandées indépendamment l'une de l'autre. Une telle structure de cellule est notamment dotée d'une marge au bruit statique en lecture (SNM) améliorée. L'invention vise également une mémoire comprenant une pluralité de telles cellules.

### ART ANTÉRIEUR

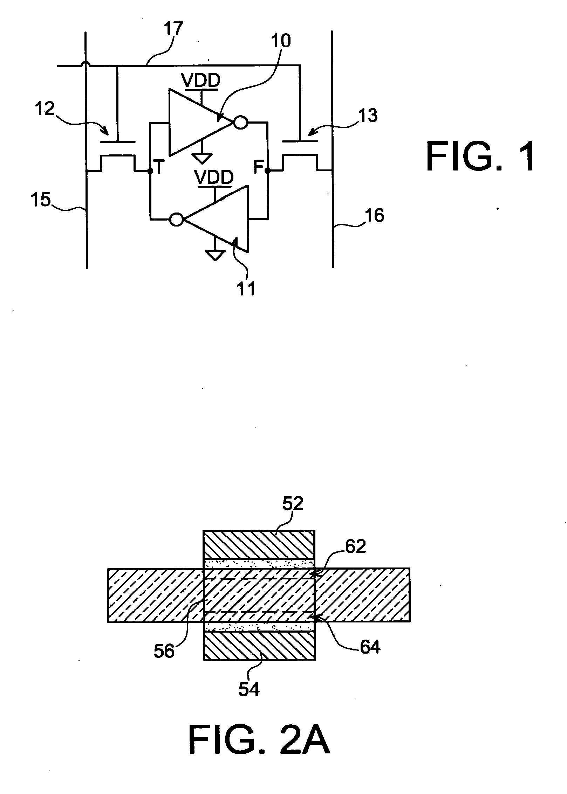

Une cellule mémoire SRAM classique (SRAM pour « static random access memory » ou mémoire vive statique) comprend généralement deux inverseurs 10, 11, connectés selon une configuration dite de bascule ou « flip-flop » et deux transistors d'accès 12, 13 connectés à des lignes dites de bit 15 et 16, et commandés par une ligne de mot 17 (figure 1).

Les caractéristiques recherchées pour une cellule mémoire sont :
- une bonne stabilité lors des différentes opérations de lecture, d'écriture, de rétention, effectuées sur la cellule,
- un courant de conduction ou de charge le plus important possible pour donner à la cellule une vitesse de fonctionnement élevée,
- une taille de cellule minimale pour permettre de réaliser une mémoire avec une densité d'intégration de cellules importante,
- un courant en rétention le plus faible possible afin de minimiser la puissance consommée statique.

Ces critères sont contradictoires entre eux et amènent les concepteurs de mémoires à faire des compromis.

Les cellules SRAM à six transistors appelées « cellules 6T », offrent un bon compromis entre tous les critères précités.

Des cellules mémoires SRAM à quatre transistors dites « cellules 4T » à encombrement réduit et permettant d'obtenir une forte densité d'intégration ont également été développées. Parmi ces cellules 4T figure une cellule de type dit « 4T-2R », qui présente un courant de rétention important et pour laquelle le rapport des largeurs respectives entre les transistors de conduction et les transistors d'accès est élevé afin d'assurer une bonne stabilité.

Le document [1] (référencé à la fin de la présente description au même titre que tous les autres documents cités dans la présente demande), présente un autre type de cellule 4T dite « 4T-Loadless » ou « 4T-sans charge ». Par rapport à la cellule 4T-2R, les résistances de charge de la cellule 4T-Loadless sont remplacées par des transistors de type TFT (TFT pour « Thin Film Transistor » ou transistors couches minces), ce qui permet de diminuer le courant direct. Une cellule 4T-Loadless a sensiblement la même taille qu'une cellule 4T-2R et consomme beaucoup moins que cette dernière, mais est en revanche sensible à la température et aux dispersions entre transistors, par exemple en termes de dopage, de longueur, de largeur. Pour compenser le manque d'un système de charge dans un tel type de cellule, des circuits supplémentaires sont à prévoir pour rafraîchir l'information mémorisée.

Des cellules SRAM à faible consommation sont présentées dans le document [2], divulguant une cellule mémoire dotée de transistors à plusieurs tensions de seuils ou « multi-VT », ainsi que dans les documents [3], [4], et [5] divulguant des cellules à modulation de tension. Dans les cellules à modulation de tension, la variation dynamique des tensions modulées, par exemple une tension d'alimentation VDD, ou/et une tension de référence VSS, ou/et une tension sur une ligne de bits, ou/et une tension sur une ligne de mot, entraînent des temps de latences importants. Afin de limiter les pénalités de délais de commutation, ces techniques de modulation de tension ne sont pas appliquées à chaque fin de cycle de lecture ou d'écriture.

En cherchant à réduire de plus en plus les tailles des transistors des cellules mémoires, les paramètres des transistors tels que leur largeur W de canal, leur longueur L de canal, leur tension de seuil V_{T}, leur perméabilité µ₀, leur dopage Na, leur épaisseur d'oxyde de grille Tox fluctuent. Cela entraîne, comme indiqué dans les documents [6] et [7], une augmentation de la sensibilité des transistors face aux différentes sources de bruit telles que le couplage capacitif, le couplage inductif, le bruit d'alimentation.

De nos jours, on cherche constamment à réduire la taille des cellules mémoires. Le développement de cellules mémoire présentant une marge au bruit élevée devient par conséquent de plus en plus une priorité.

La stabilité d'une cellule peut être déterminée notamment par sa marge au bruit statique SNM en mode lecture, comme cela est présenté dans le document [8]. Lors d'un accès en lecture d'une cellule SRAM, le gain des inverseurs est diminué par la mise en conduction des transistors d'accès. Pour annuler cet effet, une cellule à 10 transistors, dans laquelle, lors d'un cycle de lecture, les noeuds de stockage et les lignes de bit sont découplés, a été proposée dans le document [9].

Une cellule mémoire à 8 transistors réalisée en technologie double grille ayant un fonctionnement similaire à celle comportant 10 transistors évoquée précédemment, a quant elle été divulguée dans le document [10]. Malgré une forte amélioration de la marge au bruit statique SNM, les cellules à 10 transistors et à 8 transistors, ont un encombrement très important par rapport aux cellules 6T. Pour des cellules mémoire à 4 transistors ou 4T, la stabilité de la cellule en mode rétention pose quant à elle problème. Typiquement, le dimensionnement de ces cellules 4T, est réalisé en tenant compte du meilleur compromis qui peut être atteint entre la stabilité en phase de rétention et la stabilité en phase de lecture. Plusieurs solutions ont été présentées pour améliorer le rapport de ces stabilités.

Le document [11] présente par exemple un dispositif microélectronique de mémoire vive statique doté de cellules 4T réalisées sur un substrat classique également appelé « Bulk » (selon la terminologie anglo-saxonne), dans lequel la tension de la ligne de mot est réduite, afin d'augmenter la marge au bruit statique. Les cellules 4T divulguées dans ce document présentent cependant un courant de conduction faible.

Dans le document [12], des moyens de contrôle du potentiel du substrat des transistors de charge sont prévus afin d'améliorer la stabilité en rétention. Cette solution peut permettre également de mettre en oeuvre une cellule avec des transistors de taille très faible, par exemple ayant une longueur de canal de l'ordre de 0,18 µm.

Les documents [13] et [14] divulguent quant à eux une cellule appelée « 4T-SR », réalisée en technologie SOI partiellement déserté (SOI pour « silicon on insulator » ou « silicium sur isolant »), caractérisée par une autorégulation des charges des noeuds de stockage. Cette cellule 4T-SR, permet de maintenir une information stockée sans faire appel à un circuit de rafraîchissement. Un inconvénient de cette cellule est qu'elle est spécifique à la technologie SOI partiellement déserté.

Le brevet US 2005/0199964 décrit une cellule de mémoire vive à accès aléatoire comprenant une pluralité de transistors à double-grille.

Il se pose le problème de trouver une nouvelle structure de cellule mémoire SRAM, présentant d'une part une stabilité et une marge au bruit statique améliorées, tout en conservant un encombrement satisfaisant et éventuellement amélioré.

### EXPOSÉ DE L'INVENTION

L'invention concerne tout d'abord une cellule de mémoire vive à accès aléatoire selon la revendication 1.

La cellule peut être une cellule SRAM.

Lesdites première et seconde grille du premier transistor d'accès sont distinctes ou ne sont pas reliées entre elles ou ne sont pas connectées entre elles.

Lesdites première et seconde grille du deuxième transistor d'accès sont distinctes ou ne sont pas reliées ou entre elles ou ne sont pas connectées entre elles.

Selon une première possibilité, ladite cellule peut être une cellule à 6 transistors ou 6T, ladite première pluralité de transistors étant formée :
- d'un premier transistor de charge à double grille et d'un deuxième transistor de charge à double grille, les deux grilles du premier transistor de charge étant connectées ensemble, les deux grilles du deuxième transistor charge étant également connectées ensemble,
- d'un premier transistor de conduction à double grille et d'un deuxième transistor de conduction à double grille, les deux grilles du premier transistor de conduction étant connectées ensemble, les deux grilles du deuxième transistor conduction étant également connectées ensemble.

Selon une deuxième possibilité, ladite cellule peut être une cellule à 4 transistors ou 4T, ladite première pluralité de transistors étant formée :
- d'un premier transistor de charge à double grille et d'un deuxième transistor de charge à double grille, les deux grilles du premier transistor de charge étant connectées ensemble et les deux grilles du deuxième transistor charge étant également connectées ensemble.

Les transistors d'accès comportent une double-grille asymétrique, avec une première grille appelée « grille supérieure », et une deuxième grille appelée « grille inférieure » et définie comme celle des deux grilles permettant de générer le courant le plus faible, à polarisation identique.

Dans la cellule, la deuxième ligne de mot peut être dédiée aux opérations d'écriture et connectée à la grille inférieure des transistors d'accès.

Selon une possibilité de mise en oeuvre, la cellule est susceptible d'adopter un mode de rétention dans lequel la première ligne de mot et la deuxième ligne de mot sont respectivement à un premier potentiel dit « de rétention » et à un deuxième potentiel dit « de rétention », le premier potentiel de rétention et le deuxième potentiel de rétention étant prévus pour bloquer le premier transistor d'accès et le deuxième transistor d'accès.

Le premier potentiel de rétention et le deuxième potentiel de rétention peuvent éventuellement être égaux, par exemple égaux à un potentiel de référence VSS.

Selon une possibilité de mise en oeuvre, la cellule est susceptible d'adopter un mode d'écriture dans lequel la première ligne de mot et la deuxième ligne de mot sont respectivement à un premier potentiel dit « d'écriture » et à un deuxième potentiel dit « d'écriture », le premier potentiel d'écriture et le deuxième potentiel d'écriture étant prévus pour rendre passant ou saturer, le premier transistor d'accès et le deuxième transistor d'accès.

Le premier potentiel d'écriture et le deuxième potentiel d'écriture peuvent éventuellement être égaux, par exemple à un potentiel d'alimentation VDD.

Selon une possibilité de mise en oeuvre, la cellule mémoire vive à accès aléatoire, est susceptible d'adopter un mode de lecture dans lequel la première ligne de mot et la deuxième ligne de mot sont respectivement à un premier potentiel dit « de lecture » et à un deuxième potentiel dit « de lecture », le premier potentiel de lecture et le deuxième potentiel de lecture étant différents. En mode de lecture, une seule des deux lignes de mots peut être activée, par exemple de sorte qu'une des deux lignes de mots est à un potentiel d'alimentation VDD, tandis que l'autre ligne de mot est à un potentiel inférieur à VDD, par exemple à un potentiel de référence VSS.

Selon une mise en oeuvre particulière de la cellule mémoire vive à accès aléatoire, le premier potentiel de lecture et/ou le deuxième potentiel de lecture peuvent être inférieurs respectivement, au premier potentiel d'écriture et au deuxième potentiel d'écriture. En mode de lecture, une des deux lignes de mots peut être par exemple à un potentiel inférieur au potentiel VDD, par exemple à un potentiel VDD - V_{T}, avec V_{T} une tension de seuil d'un transistor, tandis que l'autre ligne de mot est à un potentiel de référence VSS.

L'invention concerne également un dispositif microélectronique de mémoire vive à accès aléatoire, comprenant une pluralité de cellules telles que décrites précédemment.

Selon une possibilité de mise en oeuvre, de ce dispositif microélectronique de mémoire vive à accès aléatoire, les cellules peuvent être agencées en une matrice divisée en au moins deux blocs comprenant respectivement une première pluralité de paires de lignes de mots, et une deuxième pluralité de paires de lignes de mots, le dispositif comprenant en outre :
- des moyens de sélection de bloc de cellules,
- des moyens d'activation de lignes mots, aptes à activer une ou plusieurs lignes de mots d'un bloc sélectionné, indépendamment des lignes de mots appartenant à l'autres bloc.

Selon une autre possibilité de mise en oeuvre, de ce dispositif microélectronique de mémoire vive à accès aléatoire, dans lequel les cellules sont agencées selon une matrice, le dispositif peut comprendre en outre :
- des moyens formant un premier décodeur, de lignes ou de colonnes de la matrice connecté à une première pluralité de lignes de mots dédiées aux opérations de lecture et d'écriture,
- des moyens formant un deuxième décodeur de colonnes ou de lignes de la matrice connecté à une deuxième pluralité de lignes de mots dédiées aux opérations d'écriture.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- la figure 1, illustre un exemple de cellule mémoire vive statique suivant l'art antérieur,
- les figures 2A et 2B, illustrent respectivement : un exemple de transistor double grille d'une cellule mémoire suivant l'invention vu en coupe, et un exemple de caractéristique courant-tension dudit transistor double-grille,
- la figure 3, illustre un premier exemple de cellule mémoire qui n'est pas suivant l'invention, dotée de 6 transistors double-grille et de deux lignes de mots,
- la figure 4 illustre un chronogramme de fonctionnement du premier exemple de cellule qui n'est pas suivant l'invention,
- la figure 5 illustre des courbes de marge au bruit statique (SNM) et de puissance statique pour le premier exemple de cellule qui n'est pas suivant l'invention en fonction d'une tension d'alimentation de cette cellule,
- la figure 6 illustre un deuxième exemple de cellule mémoire 4T qui n'est pas suivant l'invention, dotée de 4 transistors double grille et de deux lignes de mots ;
- la figure 7 illustre un chronogramme de fonctionnement du deuxième exemple de cellule qui n'est pas suivant l'invention,
- la figure 8 illustre une variante du deuxième exemple de cellule mémoire 4T qui n'est pas suivant l'invention, également dotée de 4 transistors double grille et de deux lignes de mots,
- la figure 9 illustre un dispositif de mémoire statique doté d'une matrice de cellules mémoires qui n'est pas suivant l'invention,
- la figure 10 illustre, un exemple de matrice 4*4 non multiplexée, de cellules mémoires qui n'est pas suivant l'invention,
- la figure 11 illustre, un exemple de matrice 4*4 multiplexée, de cellules mémoires qui n'est pas suivant l'invention,
- la figure 12 donne l'évolution du courant de canal, d'un exemple de transistor double-grille asymétrique intégré à une cellule mémoire suivant l'invention, en fonction de la polarisation de ses deux grilles,
- la figure 13 illustre, un exemple de cellule mémoire suivant l'invention, dotée de 6 transistors double-grille et de deux lignes de mots, et comportant deux transistors d'accès à double-grille asymétrique,
- la figure 14 illustre, un autre exemple de cellule mémoire suivant l'invention, dotée de 4 transistors double-grille et de deux lignes de mots, et comportant deux transistors d'accès à double-grille asymétrique,
- la figure 15 illustre, une variante de l'exemple de cellule de la figure 14, également dotée de 4 transistors double-grille, de deux lignes de mots, et comportant deux transistors d'accès à double-grille asymétrique,
- la figure 16 illustre, un exemple de matrice de cellules mémoires suivant l'invention, comprenant des moyens décodeurs de ligne associés à une pluralité de lignes de mots, et des moyens décodeurs de colonnes associés à une autre pluralité de lignes de mots.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

L'invention met en oeuvre une structure de cellule mémoire à accès aléatoire (RAM) dotée de transistors réalisés en technologie double grille, par exemple de type CMOS (CMOS pour « Complementary Metal Oxide Semi-conductor » ou « semi-conducteur à oxyde de métal complémentaire »). Par transistors réalisés en technologie double grille, on entend que ces transistors comportent deux grilles G1, G2 sous forme d'une première et d'une deuxième zone 52, 54, à base de matériau de grille, réalisées de part et d'autre d'une zone active 56, par exemple formées respectivement au-dessous et au-dessus d'une zone active 56, et reliées ou connectées respectivement à des moyens de polarisation. Les deux zones 52, 54, à base de matériau de grille peuvent être éventuellement distinctes ou disjointes l'une de l'autre et ne pas être connectées entre elles ou ne pas être reliées électriquement l'une à l'autre. Dans un transistor réalisé en technologie double grille, la zone active 56 peut comprendre une première région 62 située en regard de la première zone 52 de matériau de grille et destinée à former un premier canal, et une deuxième région 64 située en regard de la deuxième zone 54 de matériau de grille et destinée à former un deuxième canal. Un tel transistor double grille est illustré selon une vue en coupe sur la figure 2A.

Une structure de cellule mémoire à accès aléatoire suivant l'invention comprend un ensemble de transistors, par exemple des transistors d'accès, dotés de deux grilles G1, G2, électriquement indépendantes, ou qui ne sont pas connectées entre elles, et qui sont reliées respectivement à des premiers moyens de polarisation, et à des deuxièmes moyens de polarisation, distincts des premiers moyens de polarisation. Les premiers moyens de polarisation et les deuxièmes moyens de polarisation peuvent comprendre respectivement : une première ligne conductrice ou de connexion dite « première ligne de mot », apte à acheminer un potentiel de polarisation, et une deuxième ligne conductrice ou de connexion dite « deuxième ligne de mot », apte à acheminer un deuxième potentiel de polarisation. La cellule comprend également un autre ensemble de transistors, par exemple des transistors de conduction ou/et de charge, comportant une double grille dotée de deux grilles reliées électriquement entre elles, ou connectées entre elles.

Les transistors de la cellule sont également mis en oeuvre de sorte que le courant entre le drain et la source Ids, est susceptible d'adopter au moins 3 niveaux différents suivant la manière dont leurs 2 grilles sont polarisées respectivement.

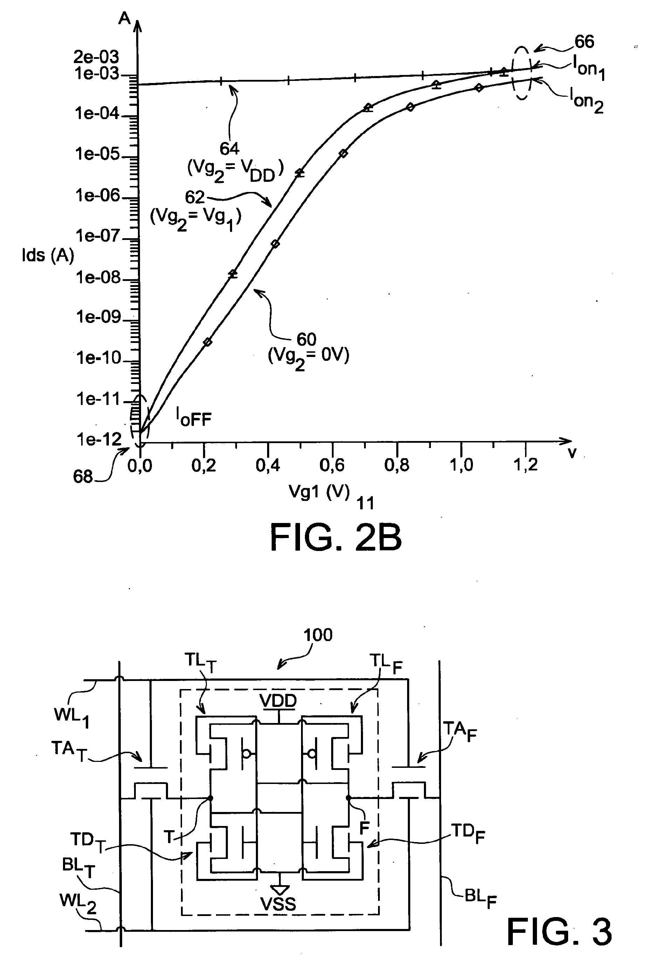

Des caractéristiques électriques d'un transistor double grille d'une cellule mémoire mise en oeuvre suivant l'invention, sont illustrées sur la figure 2B, sur laquelle trois courbes de polarisation 60, 62, 64, sont données.

Sur cette figure, une première courbe de polarisation 60 est représentative de l'évolution du courant drain-source Ids en fonction d'un potentiel Vg1 appliqué sur une première grille du transistor, lorsque la deuxième grille du transistor se trouve dans un premier état de polarisation et qu'un potentiel Vg2 = 0 Volt est appliqué sur la deuxième grille. La première courbe 60 montre que pour une polarisation telle qu'un potentiel Vg2 = 0 volt est appliqué sur la deuxième grille, on peut obtenir, le plus faible courant I_{OFF} à l'état bloqué et le plus faible courant I_{ON2} de saturation du transistor.

Une deuxième courbe de polarisation 62 est représentative de l'évolution du courant drain-source Ids en fonction d'un potentiel Vg1 appliqué sur la première grille du transistor, lorsque la deuxième grille du transistor se trouve dans un deuxième état de polarisation et qu'un potentiel Vg2 = Vg1 est appliqué sur la deuxième grille. La deuxième courbe 62 montre que pour une polarisation telle qu'un potentiel Vg2 = Vg1 est appliqué sur la deuxième grille, on peut atteindre le plus faible courant I_{OFF} à l'état bloqué du transistor et le plus fort courant I_{ON1} à l'état saturé. Une polarisation telle que Vg2 = Vg1 peut permettre d'obtenir le plus important rapport I_{ON}/I_{OFF} du courant à l'état saturé sur le courant à l'état bloqué.

Une troisième courbe de polarisation 64 est représentative de l'évolution du courant drain-source Ids en fonction d'un potentiel Vg1, appliqué sur la première grille du transistor, lorsque la deuxième grille du transistor se trouve dans un troisième état de polarisation et qu'un potentiel Vg2 = VDD, avec VDD un potentiel d'alimentation de la cellule, est appliqué sur la deuxième grille. Pour le troisième état de polarisation tel que Vg2 = VDD, on peut obtenir, lorsque Vg1 = VDD, le plus fort courant I_{ON1} de saturation du transistor et, lorsque Vg1 = 0 volt, le plus faible courant I_{ON2} de saturation du transistor.

Pour des grilles G1 et G2 de dimension critique de l'ordre de 40 nanomètres, le courant ION (zone référencée 66 sur la figure 2B) à l'état passant du transistor peut être par exemple de l'ordre de 1 mA ou compris par exemple entre 0,4 mA et 0,6 mA pour une tension de polarisation de l'ordre de 1,2 volts, tandis que le courant I_{OFF} (zone référencée 68 sur la figure 2B) à l'état bloqué, est plus faible et peut être par exemple de l'ordre de 1 pA par exemple compris entre 2 pA et 0,9 pA.

Un premier exemple de cellule mémoire qui n'est pas suivant l'invention est illustré sur la figure 3. Cette cellule, référencée 100, est une cellule dite « 6T » de type SRAM, dotée de 6 transistors réalisés en technologie MOS (MOS pour « Metal Oxide Semi-conductor » ou « semi-conducteur à oxyde de métal ») double grille. La cellule 100 comprend un premier transistor de charge à double grille TL_{T}, ainsi qu'un deuxième transistor de charge à double grille TL_{F}. Les transistors de charge TL_{T} et TL_{F}, peuvent être réalisés dans un premier type de technologie MOS donnée, par exemple une technologie de type PMOS. Les deux grilles du premier transistor de charge à double grille TL_{T} sont connectées ensemble, tandis que les deux grilles du deuxième transistor de charge à double grille TL_{F} sont également connectées ensemble. La double grille du deuxième transistor de charge TL_{F} est également reliée à un premier noeud de stockage T de la cellule 100, tandis que la double grille du premier transistor de charge TL_{T} est reliée à un deuxième noeud de stockage F de la cellule 100. Les sources des transistors de charge TL_{T}, TL_{F} sont connectées entre elles et à un potentiel d'alimentation VDD. Le potentiel d'alimentation VDD peut être par exemple de l'ordre de 1,2 volts pour des grilles de dimension critique de l'ordre de 40 nanomètres. Le potentiel d'alimentation VDD peut être adapté en fonction de l'application visée pour la cellule 100. Pour une application dans laquelle on privilégie une basse consommation pour la cellule 100, le potentiel d'alimentation peut être par exemple diminué et inférieur à 1,2 volts.

Le drain du premier transistor de charge TL_{T} et le drain du deuxième transistor de charge TL_{F}, sont reliés respectivement au premier noeud de stockage T de la cellule 100 et au deuxième noeud de stockage F de la cellule 100. La cellule 100 comprend également un premier transistor de conduction à double grille TD_{T}, ainsi qu'un deuxième transistor de conduction à double grille TD_{F}. Les transistors de conduction TD_{T} et TD_{F}, peuvent être réalisés dans un type de technologie MOS complémentaire dudit premier type, par exemple une technologie NMOS. Les deux grilles du premier transistor de conduction TD_{T} sont connectées ensemble, tandis que les deux grilles du deuxième transistor de conduction TD_{F} sont également connectées ensemble. La double grille du premier transistor de conduction TD_{T} est également reliée au deuxième noeud de stockage F, tandis que la double grille du deuxième transistor de conduction TD_{F} est connectée au premier noeud de stockage T de la cellule 100. Les sources des transistors de conduction TD_{T}, TD_{F} sont connectées entre elles et à un potentiel de référence VSS. Le potentiel de référence peut être par exemple de l'ordre de 0 Volt. Le potentiel d'alimentation VSS peut être adapté suivant l'application visée pour la cellule 100, par exemple augmenté, par exemple supérieur à 0 Volt pour limiter la consommation de la cellule 100 ou diminué, par exemple inférieur à 0 Volt pour améliorer la stabilité de la cellule 100. Le drain du deuxième transistor de conduction TD_{F} et le drain du premier transistor de conduction TD_{T} sont reliés respectivement au deuxième noeud de stockage F de la cellule 100 et au premier noeud de stockage T de la cellule 100.

Les transistors de charge TL_{T}, TL_{F} et de conduction TD_{T}, TD_{F} forment un bistable pour la cellule 100, et sont prévus pour contrôler et maintenir une information gardée par les noeuds de stockage T, F. Le premier noeud de stockage T, peut être destiné à conserver une information logique donnée, tandis que le deuxième noeud de stockage F est destiné à garder une information logique complémentaire de l'information logique.

La cellule 100 est également dotée d'un premier transistor d'accès TA_{T} à double grille et d'un deuxième transistor d'accès TA_{F} à double grille, par exemple de type NMOS. Le premier transistor d'accès TA_{T} comporte une grille reliée à une première ligne de mot WL₁ et une autre grille reliée à une deuxième ligne de mot WL₂. La première ligne de mot WL₁ et la deuxième ligne de mot WL₂ sont destinées respectivement, à acheminer un premier potentiel de polarisation et un deuxième potentiel de polarisation. La manière dont les lignes de mot WL₁ et WL₂ sont polarisées respectivement, détermine les différentes phases de fonctionnement de la cellule 100 : de lecture, d'écriture, et de rétention. Le deuxième transistor d'accès TA_{F} est également doté d'une grille reliée à la première ligne de mot WL₁ et d'une deuxième grille reliée à la deuxième ligne de mot WL₂. La source du premier transistor d'accès TA_{T} est reliée à une première ligne de bit BL_{T}, tandis que la source du deuxième transistor d' accès TA_{F} est reliée à une deuxième ligne de bit BL_{F}. Les lignes de bits BL_{T} et BL_{F} sont susceptibles notamment de transmettre des données à écrire dans la cellule. Le drain du premier transistor d'accès TA_{T} est relié au premier noeud T, tandis que le drain du deuxième transistor d'accès TA_{F} est relié au deuxième noeud F. Les transistors d'accès TA_{T}, TA_{F}, sont agencés pour permettre d'accéder aux noeuds de stockage T et F, lors d'une phase de lecture ou d'écriture de la cellule 100, et bloquer l'accès de la cellule 100, lorsque la cellule 100 est dans un mode de rétention d'information.

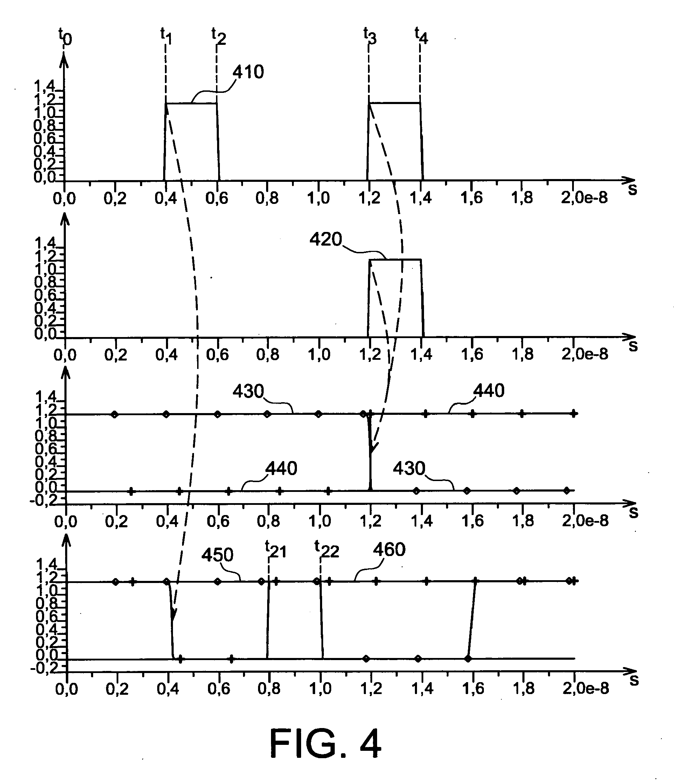

Un exemple de fonctionnement de la cellule mémoire 100 qui vient d'être décrite, va à présent être donné en liaison avec le chronogramme de la figure 4. Sur ce chronogramme, les différents phases de fonctionnement de la cellule 100 sont illustrées, à l'aide de courbes d'évolutions 410, 420, 430, 440, 450, 460, respectivement, du potentiel de la première ligne de mot WL₁, du potentiel de la deuxième ligne de mot WL₂, du potentiel au premier noeud T, du potentiel au deuxième noeud F, du potentiel de la première ligne de bit BL_{T}, du potentiel de la deuxième ligne de bit BL_{F}.

Sur ce chronogramme, entre un instant t₀ et un instant t₁, la cellule 100 est placée en mode de rétention. Une information gardée par la cellule 100 entre t₀ et t₁, est par exemple un niveau logique '0' (courbe 440 à un état bas) au deuxième noeud F, et un niveau logique '1' (courbe 430 à un état haut) au premier noeud T. Les lignes de mot WL₁, WL₂, sont quant à elles mises respectivement à un premier potentiel dit de « rétention » et à un deuxième potentiel dit de « rétention » égal au premier potentiel de rétention. Le premier potentiel de rétention et le deuxième potentiel de rétention peuvent être choisis de manière à bloquer les transistors d'accès TA_{T}, TA_{F}, ou l'accès aux noeuds de stockage T et F. Le premier potentiel de rétention et le deuxième potentiel de rétention peuvent être par exemple égaux au potentiel de référence VSS (courbes 410 et 420 à un état bas). Lors de la phase de rétention, les lignes de mot WL₁, WL₂, sont dites « désactivées ».

Préalablement à une entrée en phase de lecture à l'instant t₁, les lignes de bit BL_{T}, BL_{F}, peuvent quant à elles, être polarisées à un même potentiel, par exemple au potentiel de référence VSS (courbes 450 et 460 à l'état bas) entre l'instant t₀ et l'instant t₁.

A l'instant t₁, la cellule 100 passe en mode de lecture. Cela se traduit par un changement de polarisation d'une des deux lignes de mots WL₁, WL₂, par exemple de la première ligne de mot WL₁, qui, à l'instant t₁, est mise à un potentiel dit « de lecture » différent de celui qu'elle avait lors du mode de rétention, par exemple au potentiel d'alimentation VDD (courbe 410 passant à l'état haut) tandis que l'autre des deux lignes de mot, par exemple la deuxième ligne de mot WL₂, est maintenue à un potentiel dit de « lecture » égal à celui qu'elle avait lors du mode de rétention, par exemple égal au potentiel de référence VSS (courbe 420 restant à l'état bas). Le changement de polarisation d'une des deux lignes de mots WL₁, WL₂, à l'instant t₁, entraîne ou est suivi d'un changement de potentiel d'une des lignes de bit, par exemple de la deuxième ligne de bit BL_{F} (passage de la courbe 460 à un état bas), tandis que l'autre ligne de bit, par exemple la première ligne de bit BL_{T} est maintenue au même potentiel. Pendant la phase de lecture, les transistors d'accès TA_{T} et TA_{F} sont polarisés par l'intermédiaire des lignes de mots WL₁ et WL₂, de manière à permettre un accès aux noeuds de stockage T et F, tout en empêchant de modifier l'information présente respectivement sur ces noeuds T et F. Lors de la phase de lecture, les lignes de mot WL₁, WL₂, sont à des potentiels différents. Une des deux lignes de mots, est dite « active », par exemple la première ligne de mot WL₁, tandis que l'autre des deux lignes de mots est dite « désactivée », par exemple la deuxième ligne de mot WL₂. En mode lecture, la stabilité de la cellule 100 dépend, d'une part de la relation entre les courants de conduction du deuxième transistor de conduction TD_{F} et du deuxième transistor d'accès TA_{F} pour maintenir par exemple le niveau logique `0' au deuxième noeud F, et d'autre part du courant fourni par le transistor de charge TL_{T} pour maintenir le niveau logique '1' au premier noeud T. L'agencement des transistors de la cellule 100 et leur polarisation lors de la phase de lecture, sont prévus de sorte que le courant de conduction ICELL qui traverse le deuxième transistor d'accès TA_{F} est inférieur au courant de conduction du deuxième transistor de conduction TD_{F}. L'agencement des transistors de la cellule 100 et leur polarisation lors de la phase de lecture, peuvent également être prévus de sorte que le courant délivré par le premier transistor de charge TL_{T} compense les pertes de charge au premier noeud T évacuées par le premier transistor de conduction TD_{T}. Cela peut permettre d'obtenir une marge au bruit statique maximale, par exemple de l'ordre de 352 mV. L'activation d'une seule des deux lignes de mot WL1 et WL2 pendant la phase de lecture, permet, comme cela est illustré sur la figure 2B, de limiter le courant de conduction ICELL et ainsi d'améliorer fortement la stabilité de la cellule 100. Pendant la phase de lecture le deuxième transistor d'accès TA_{F} a un seul canal activé, tandis que le premier transistor de charge TL_{T} et le deuxième transistor de conduction TD_{F} ont leurs deux canaux activés.

A un instant t₂, le potentiel de la première ligne de mot WL₁ est à nouveau modifié, et repasse par exemple au potentiel de référence VSS (passage de la courbe 410 à l'état bas). Les potentiels de la première ligne de mot WL₁ et de la deuxième ligne de mot WL₂ sont égaux et établis de manière à bloquer à nouveau l'accès aux noeuds T et F, et à mettre à nouveau la cellule 100 dans un mode de rétention. A un instant t₂₁ situé après la phase de lecture et avant la phase d'écriture, la deuxième ligne de bits BLF est rechargée (passage de la courbe 460 à l'état haut). Puis, à un instant t₂₂, situé avant la phase d'écriture, la première ligne de bits BLT est initialisée (passage de la courbe 450 à l'état bas).

Entre un instant t₃ et un instant t₄, la cellule 100 est placée dans une phase ou un mode d'écriture. En mode écriture, les deux lignes de mots WL₁ et WL₂ sont polarisées respectivement par un premier potentiel dit « d'écriture », et un deuxième potentiel dit « d'écriture », choisis de manière à activer ou rendre passant ou saturer les transistors d'accès. Les deux lignes de mots WL₁ et WL₂ peuvent être mises au même potentiel, par exemple au potentiel d'alimentation VDD (courbes 450 et 460 à l'état haut) lors de la phase d'écriture. L'agencement des transistors d'accès TA_{T} et TA_{F} de la cellule 100, ainsi que les potentiels respectifs de polarisation des deux lignes de mot WL₁ et WL₂ sont choisis pour la phase d'écriture, de manière à générer un courant de conduction ICELL permettant de faire commuter la cellule 100 (changement d'état des courbes 430 et 440). La commutation de la cellule 100 ou le changement des potentiels respectifs du premier noeud T et du deuxième noeud F, est réalisée avec une différence de potentiel entre les lignes de bits BL_{T} et BL_{F}, la plus faible possible. Lors de la phase d'écriture, les lignes de mot WL₁, WL₂, sont à des potentiels identiques. En mode d'écriture, la première ligne de mot WL₁ et la deuxième ligne de mot WL₂ sont dites « actives ».

Les caractéristiques électriques de la cellule 100 qui vient d'être décrite sont améliorées par rapport à une cellule 6T suivant l'art antérieur, développée par exemple en technologie CMOS et avec un dimensionnement des transistors qui serait identique à celui de la cellule 100. La marge au bruit statique de la cellule 100 peut être améliorée par exemple de 100 mV ou de l'ordre de 40 %. Une telle amélioration peut permettre d'alimenter la cellule 100 avec une tension d'alimentation VDD réduite, par exemple comprise entre 700 mV et 800 mV.

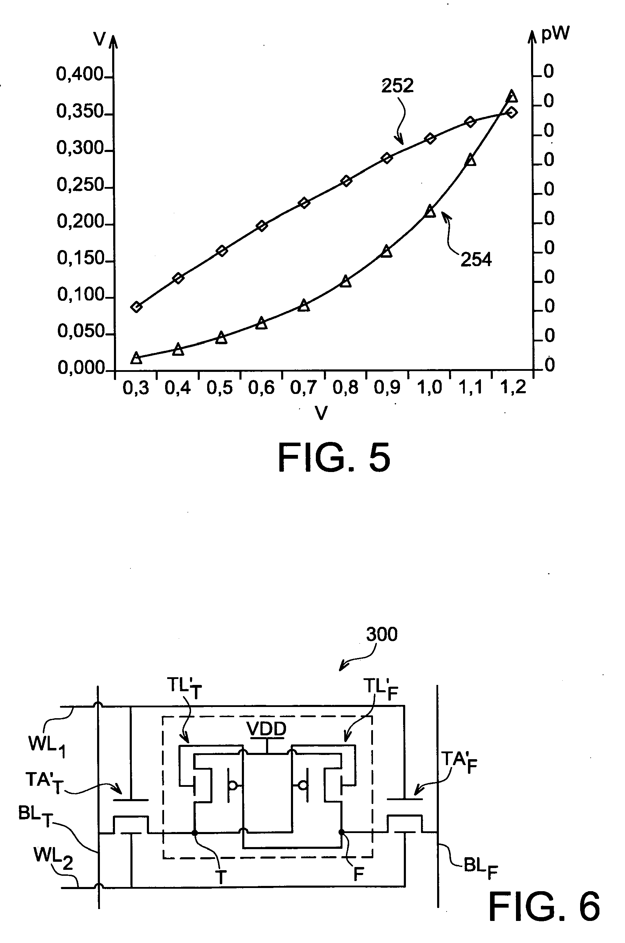

La figure 5 illustre des performances électriques de la cellule 100. Sur cette figure, des courbes 252, 254, respectivement, de variation de la marge au bruit statique de la cellule 100 en fonction de sa tension d'alimentation VDD, et de variation de la puissance statique de la cellule 100 en fonction de la tension d'alimentation VDD, sont données. Pour une différence de tension d'alimentation d'environ 400 mV, la marge au bruit statique de la cellule 100 et d'une cellule 6T standard peuvent être égales, mais avec une consommation de la cellule 100 divisée par 3 par rapport à celle de la cellule 6T standard.

Un deuxième exemple de cellule mémoire 300 à accès aléatoire qui n'est pas suivant l'invention, est illustré sur la figure 6. Cette cellule mémoire 300 est une cellule 4T, dotée de 4 transistors réalisés en technologie double grille. Les transistors peuvent être des transistors de type MOS. La cellule mémoire 300 a un encombrement plus faible que celui de la cellule 100 décrite précédemment en liaison avec la figure 3.

La cellule 300 comprend un premier transistor de charge à double grille TL'_{T}, ainsi qu'un deuxième transistor de charge à double grille TL'_{F}. Les transistors de charge TL'_{T} et TL'_{F}, peuvent être réalisés dans un premier type de technologie MOS donnée, par exemple une technologie de type PMOS. Les deux grilles du premier transistor de charge TL'_{T} sont connectées l'une à l'autre, tandis que les deux grilles du deuxième transistor de charge TL'_{F} F sont également connectées ensemble. La double grille du deuxième transistor de charge TL'_{F} est également connectée à un premier noeud de stockage T de la cellule 300, tandis que la double grille du premier transistor de charge TL'_{T} est également connectée à un deuxième noeud de stockage F de la cellule 300. Les sources des transistors de charge TL'_{T}, TL'_{F}, sont quant à elles reliées entre elles et à un potentiel d'alimentation VDD, tandis que le drain du premier transistor de charge TL'_{T} est relié au premier noeud T et que le drain du deuxième transistor de charge TL'_{F} est relié au deuxième noeud F. Les transistors de charge TL'_{T} et TL'_{T} sont prévus pour maintenir une charge nécessaire à l'établissement d'un niveau logique donné par exemple '1', correspondant par exemple à un potentiel égal au potentiel d'alimentation VDD, sur l'un ou l'autre des noeuds T ou F, en fonction de la valeur logique mémorisée dans la cellule 300.

La cellule 300 est également dotée d'un premier transistor d'accès TA'_{T} à double grille et d'un deuxième transistor d'accès TA'_{F} à double grille, par exemple de type NMOS. Le premier transistor d'accès TA'_{T} comporte une grille reliée à une première ligne de mot WL₁ et une autre grille reliée à une deuxième ligne de mot WL₂. Le deuxième transistor d'accès TA'_{F} comporte également une grille reliée à la première ligne de mot WL₁ et une deuxième grille reliée à la deuxième ligne de mot WL₂. La source du premier transistor d'accès TA'_{T} est reliée à une première ligne de bit BL_{T}, tandis que la source du deuxième transistor d'accès TA'_{F} est reliée à une deuxième ligne de bit BL_{F}. Le drain du premier transistor d'accès TA'_{T} est quant à lui relié au premier noeud de stockage T, tandis que le drain du deuxième transistor d'accès TA'_{F} est relié au deuxième noeud de stockage F. Les transistors d'accès TA' _{T}, TA'_{F}, sont agencés pour permettre d'accéder aux noeuds de stockage T et F, lors d'une phase de lecture ou d'écriture de la cellule 300, et à bloquer l'accès de la cellule 300, lorsque la cellule 300 est dans un mode de rétention d'information.

Une telle cellule 300 permet d'obtenir un compromis amélioré entre la stabilité en rétention et la stabilité en lecture. Un maintien de l'information stockée en rétention sans faire appel à des moyens de rafraîchissement est également réalisé. Les lignes de mots WL₁, WL₂, sont commandées en fonction du mode dans lequel on souhaite placer la cellule 300.

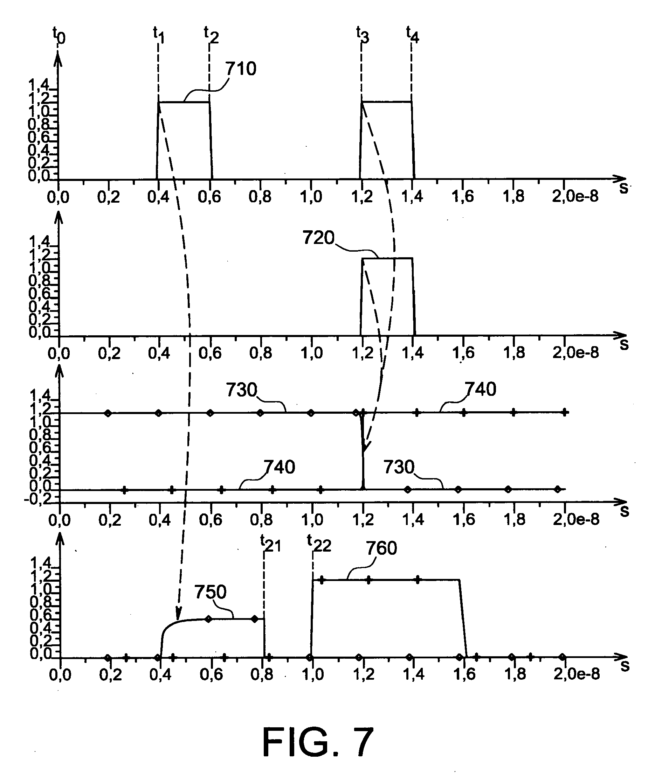

Un mode de fonctionnement du deuxième exemple de cellule 300, va à présent être donné en liaison avec le chronogramme de la figure 7.

Sur ce chronogramme, les différents états de la cellule 300 sont illustrés à l'aide de courbes d'évolutions 710, 720, 730, 740, 750, 760, respectivement, du potentiel de la première ligne de mot WL₁, du potentiel de la deuxième ligne de mot WL₂, du potentiel au premier noeud T, du potentiel au deuxième noeud F, du potentiel sur la première ligne de bit BL_{T}, et du potentiel sur la deuxième ligne de bit BL_{F}.

Initialement, dans cet exemple, la cellule 300 conserve une information telle que le premier noeud T est à un niveau logique '1', et telle que le deuxième noeud F est à un niveau logique '0' . Entre un instant t₀ et un instant t₁ sur le chronogramme, la cellule 300 est mise dans un mode de rétention. En mode de rétention, les lignes de bit BL_{T}, BL_{F}, sont à des potentiels, par exemple égaux au potentiel de référence VSS (courbes 750 et 760 à un état bas), et choisis de manière stabiliser une donnée mémorisée dans la cellule 300, tandis que les lignes de mot WL₁, WL₂, sont maintenues respectivement à un premier potentiel dit « de rétention » et à un deuxième potentiel dit « de rétention ». Le premier potentiel de rétention et le deuxième potentiel de rétention peuvent être égaux entre eux et choisis, par exemple égaux au potentiel de référence VSS, de manière à bloquer l'accès aux noeuds T et F (courbes 710 et 720 à un état bas). Les lignes de mot WL₁, WL₂, sont dites désactivées en mode de rétention. Dans un cas où le premier noeud T est à un niveau logique T = 1 et où le deuxième noeud F est à un niveau logique F = 0, le deuxième transistor de charge TL'_{F} est également bloqué, tandis que le premier transistor de charge TL'_{T} est conducteur. En phase de rétention, pour garder au même potentiel le deuxième noeud F, c'est-à-dire par exemple à un potentiel proche du potentiel de référence VSS, l'agencement et la polarisation des transistors de la cellule 300 sont prévus de sorte que le courant traversant le deuxième transistor d'accès TA'_{F} est supérieur à la somme du courant traversant le deuxième transistor de charge TL'_{F}, et du courant de grille issu du premier transistor de charge TL'_{T}.

Puis, à partir d'un instant t₁ et jusqu'à un instant t₂, la cellule 300 passe en mode de lecture. Cela se traduit par un changement de potentiel sur une seule des deux lignes de mot WL₁ et WL₂, par exemple la première ligne WL₁ de mot, qui est mise à un potentiel de lecture, par exemple égal au potentiel d'alimentation VDD (passage d'un état bas à un état haut de la courbe 710), tandis que l'autre ligne de mot, par exemple la deuxième ligne de mot WL₂, est maintenue au même potentiel, par exemple au potentiel de référence VSS (maintien de la courbe 720 à l'état bas), de manière à permettre un accès aux noeuds de stockage T, F. En phase de lecture, une seule des deux lignes de mots est activée par exemple la première ligne de mot WL₁, de manière à permettre un accès aux noeuds T et F, tout en conservant l'information présente sur ces derniers. Le changement de polarisation d'une des deux lignes de mots WL₁, WL₂, à l'instant t₁, entraîne un changement de potentiel d'une des lignes de bit, par exemple de la première ligne de bit BLT (passage de la courbe 750 à un état haut). La ligne de bit dont le potentiel change à partir de t₁ peut être mise à un potentiel donné. Le potentiel donné peut correspondre au potentiel du premier noeud de stockage, diminué d'une tension de seuil de transistor.

Dans cet exemple, la stabilité de la deuxième cellule 300 en mode lecture dépend de la relation entre les courants de conduction du premier transistor de charge TL'_{T} et du premier transistor d'accès TA'_{T}. Afin d'obtenir une marge au bruit importante, l'agencement des transistors et leur polarisation lors de la phase de lecture, sont prévus de sorte que le courant de conduction ICELL qui traverse le premier transistor d'accès TA'_{T} est inférieur au courant de conduction du premier transistor de charge TL'_{T}. L'activation d'une seule des deux lignes de mot permet de limiter le courant ICELL et ainsi de garantir une forte stabilité de la cellule.

Entre un instant t₂ et jusqu'à un instant t₃, la cellule 300 passe à nouveau en mode rétention.

A un instant t₂₁ après la phase de lecture et avant la phase d'écriture, le potentiel appliqué sur la ligne de bits BLF est modifié (passage de la courbe 750 à l'état bas), de manière à préparer la cellule à une phase d'écriture. Puis, à un instant t₂₂, avant la phase d'écriture, la deuxième ligne de bits BLF est mise à un potentiel représentatif d'une donnée destinée à être écrite lors de la phase d'écriture (passage de la courbe 760 à l'état haut). Puis, à un instant t₃ et jusqu' à un instant t₄, la cellule 300 est mise en mode écriture. A l'instant t₃, les deux lignes de mot WL₁ et WL₂ sont mises à des potentiels dits « d'écriture » prévus pour activer les transistors d'accès TA'_{T} et TA'_{F} et générer un courant de conduction ICELL maximal de manière à faire commuter la cellule 300 avec une faible différence de potentiel entre les lignes de bit BL_{T} et BL_{F}. En phase d'écriture, les deux lignes de mot WL₁ et WL₂ sont toutes les deux activées et peuvent être mises au même potentiel, par exemple au potentiel d'alimentation VDD.

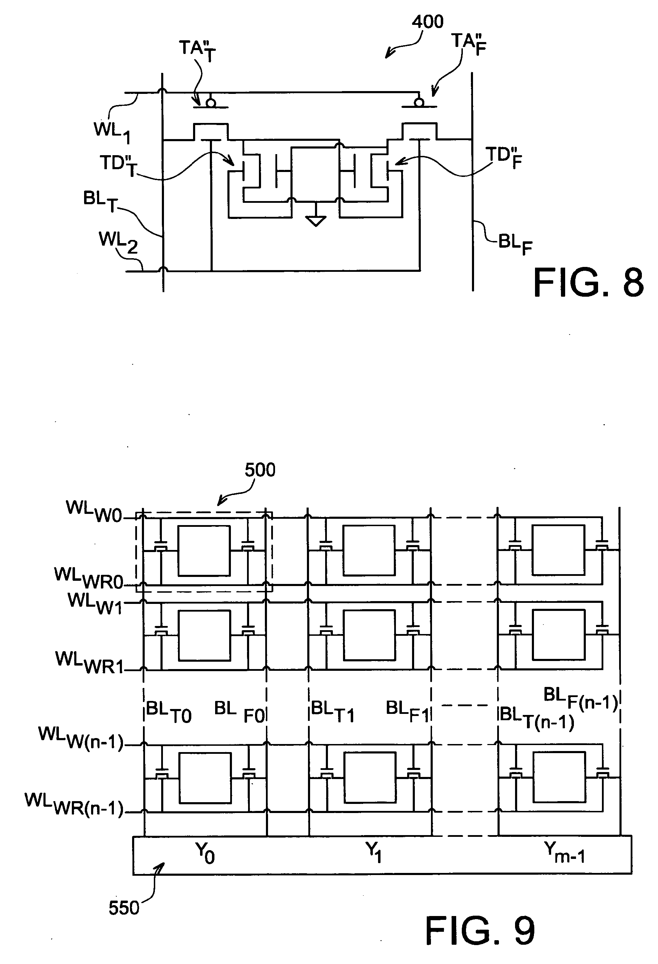

Une variante de la cellule 300 décrite précédemment, est illustrée sur la figure 8. Cette variante met en oeuvre une cellule 400 à 4 transistors, dans laquelle les transistors de charge TL'_{T} et TL'_{F} sont remplacés par un premier transistor de conduction double grille TD"_{T} et un deuxième transistor de conduction double grille TD"_{F}. Les transistors de conduction double grille TD"_{T} et TD"_{F} peuvent être réalisés par exemple dans une technologie MOS complémentaire de celle des transistors de charge TL'_{T} et TL'_{F} de la cellule 300, par exemple une technologie NMOS. L'activation de la cellule 400 par les lignes de mots WL₁ et WL₂, peut être la complémentaire de celle de la cellule 300.

Les deux grilles du premier transistor de conduction TD"_{T} sont connectées l'une à l'autre, tandis que les deux grilles du deuxième transistor de charge TD"_{F} sont également connectées ensemble. La double grille du deuxième transistor de conduction TD"_{F} est connectée à un premier noeud de stockage T de la cellule 400, tandis que la double grille du premier transistor de conduction TD"_{T} est également connectée à un deuxième noeud de stockage F de la cellule 400. Les sources des transistors de conduction TD"_{T}, TD"_{F} sont connectées entre elles et à un potentiel de référence VSS, tandis que le drain du premier transistor de conduction TD"_{T} est relié au premier noeud T et que le drain du deuxième transistor de conduction TD"_{F} est relié au deuxième noeud F.

La cellule 400 est également dotée d'un premier transistor d'accès TA" _{T} à double grille et d'un deuxième transistor d'accès TA"_{F} à double grille, réalisés par exemple dans une technologie MOS complémentaire de celle des transistors TA" _{T} et TA" _{F} de la cellule 300. Le premier transistor d'accès TA" _{T} comporte une grille reliée à une première ligne de mot WL1 et une autre grille reliée à une deuxième ligne de mot WL2. Le deuxième transistor d'accès TA"_{F} comporte également une grille reliée à la première ligne de mot WL1 et une deuxième grille reliée à la deuxième ligne de mot WL2. Le drain du premier transistor d'accès TA"_{T} est relié à une première ligne de bit BL_{T}, tandis que le drain du deuxième transistor d'accès TA" _{F} est reliée à une deuxième ligne de bit BL_{F}. La source du premier transistor d'accès TA" _{T} est reliée au premier noeud de stockage T, tandis que la source du deuxième transistor d'accès TA" _{F} est relié au deuxième noeud de stockage F. Les transistors d'accès TA" _{T}, TA" _{F}, sont agencés pour permettre d'accéder aux noeuds de stockage T et F, lors d'une phase de lecture ou d'écriture de la cellule 400, et à bloquer l'accès de la cellule 400, lorsque la cellule 400 est dans un mode de rétention d'information.

Selon une possibilité de mise en oeuvre, la polarisation des cellules 100, ou 300, lors de la phase de lecture, peut être prévue de sorte qu'une des deux lignes de mot, par exemple la deuxième ligne de mot WL2, n'est pas activée, tandis que l'autre ligne de mot, par exemple la première ligne de mot WL1 est activée et mise à un potentiel réduit, par exemple égal à VDD - V_{T} par rapport au potentiel VDD auquel elle se trouve lors de la phase de d'écriture, avec V_{T} une tension de seuil de transistor.

Selon une possibilité de mise en oeuvre des transistors d'accès des cellules 100, et/ou 300, et/ou 400, le premier transistor d'accès et/ou le deuxième transistor d'accès, peut ou peuvent être doté(s) respectivement d'une première grille accolée à une épaisseur de diélectrique de grille donnée et d'une deuxième grille accolée à une deuxième épaisseur de diélectrique de grille différente de celle de la première épaisseur. Cela peut permettre d'améliorer la stabilité en rétention de la cellule.

Une comparaison de caractéristiques électriques de la cellule 100 de type 6T, de la cellule 300 de type 4T, décrites précédemment, par rapport à celles d'une cellule à 6 transistors suivant l'art antérieur, dite « 6T standard », va à présent être donnée en liaison avec le tableau ci-dessous. Les caractéristiques électriques figurant dans ce tableau ont été obtenues pour des cellules 100, 300, et 6T standard réalisées avec une longueur de canal de 40 nm. Les cellules 100, 300, 6T-standard ont été mises en oeuvre de manière à ce qu'elles présentent sensiblement le même courant de fuite en mode rétention I_{OFF}.

| **Cellules** | **6T-standard** | **Cellule 100** | **Cellule 300** |
|---|---|---|---|
| I_{OFF} (pA) | 390 | 390 | 360 |
| I_{PG} (pA) | 9 | 9 | 360 |
| I_{CELL RD} (µA) | 180 | 94 | 195 |
| I_{CELL WR} (µA) | 180 | 180 | 340 |
| NBL (x10⁶) | 19,4 | 10,2 | 0,54 |
| SNM (mV) | 251 | 352 | 210 |
| WM (mV) | 945 | 948 | 58 |
| WD (ms) | - | - | 0.3 |
| ΣWL (µm²) | 70,3 | 70,3 | 53,05 |

Dans ce tableau .
- un facteur noté NBL, est représentatif d'un nombre de cellules par ligne de bit, calculé par rapport au courant de fuite des transistors d'accès I_{PG} et à un courant de conduction de la cellule en mode lecture ou de saturation dynamique des transistors d'accès de la cellule ICELL_RD, tel que : (ICELL_RD/I_{PG)}> x*N_{WL}, avec x un facteur de marge habituellement compris entre 5 et 10 et N_{WL} le nombre de ligne de mots,
- un facteur ICELL_WR donne le courant de conduction de la cellule en écriture,
- des facteurs de marge au bruit statique SNM et de marge en écriture WM, sont représentatifs respectivement du comportement de la cellule par rapport aux cycles de lecture, et du comportement de la cellule par rapport aux cycles d'écriture,
- un facteur de sensibilité en écriture WD caractérise, pour la cellule 300, la perte de l'information stockée dans une cellule en rétention lors d'une écriture d'une autre cellule de la même colonne,
- un facteur Σ(W*L) donne la somme des surfaces respectives des canaux de tous transistors d'une cellule, de manière à comparer l'encombrement des différentes cellules.

La marge au bruit statique de la cellule 100, peut être améliorée de 100mV soit de l'ordre de 40 % par rapport à une cellule 6T standard. Ce gain de marge au bruit statique permet de mettre en oeuvre une cellule 100 basse consommation et d'alimenter cette cellule 100 avec une tension d'alimentation VDD, par exemple comprise entre 600 mV et 1,1 volts ou entre 600 mV et 900 mV, ou entre 600 mV et 800 mV, inférieure à celle d'une cellule 6T standard.

En ce qui concerne la cellule 300, en éliminant le chemin vers la masse, le courant de conduction ICELL_RD en mode de lecture peut être augmenté de l'ordre de 8 % tandis que la marge en écriture peut être divisée de l'ordre d'un facteur 16 par rapport à la cellule 6T standard.

En ce qui concerne l'encombrement, ce dernier peut être amélioré de l'ordre de 30 % pour la cellule 300 par rapport à une cellule 6T standard.
Un dispositif microélectronique de mémoire vive statique doté d'une pluralité de cellules mémoires 500 qui ne sont pas suivant l'invention et semblables à l'une ou l'autre des cellules 100, 300 ou 400 décrites précédemment, est illustrée sur la figure 9. La mémoire a un agencement matriciel et est formée de n colonnes, chaque colonne comprenant m cellules 500. Chacune des colonnes de la matrice comprend deux lignes de bit BLT₀, BLF₀ , ..., BLT(ₘ₋₁), BLF₍ₘ₋₁₎ et est contrôlée par un décodeur de colonne 550. Les m*n cellules mémoires 500 sont commandées par 2*m lignes de mot, dont m lignes de mot WL_{WR0}, ..., WL_{WR(n-1)} aptes, lorsqu'elles sont activées, à commander une opération de lecture et 2*m lignes de mot WL_{WR0}, ..., WL_{WR(n-1)} et WL_{W0, ...}, WL_{W(n-1)} aptes, lorsqu'elles sont activées, à commander une opération d'écriture (m*(WLW + WLRW)).

Les cellules à 6 transistors ou à 4 transistors qui ne sont pas suivant l'invention, comportent une ligne de mot supplémentaire permettant notamment d'améliorer la marge en écriture. Il peut être prévu que cette ligne de mot soit activée uniquement lors d'un cycle d'écriture.

Une implantation dans une matrice mémoire simple, non multiplexée, vient d'être donnée en liaison avec la figure 9. Dans ce cas, la différence avec une implantation conventionnelle, se situe notamment au niveau du fonctionnement du décodeur de ligne. Ce décodeur peut être prévu de manière à n'activer la ligne de mot dédiée à l'écriture, uniquement lors d'une opération d'écriture.

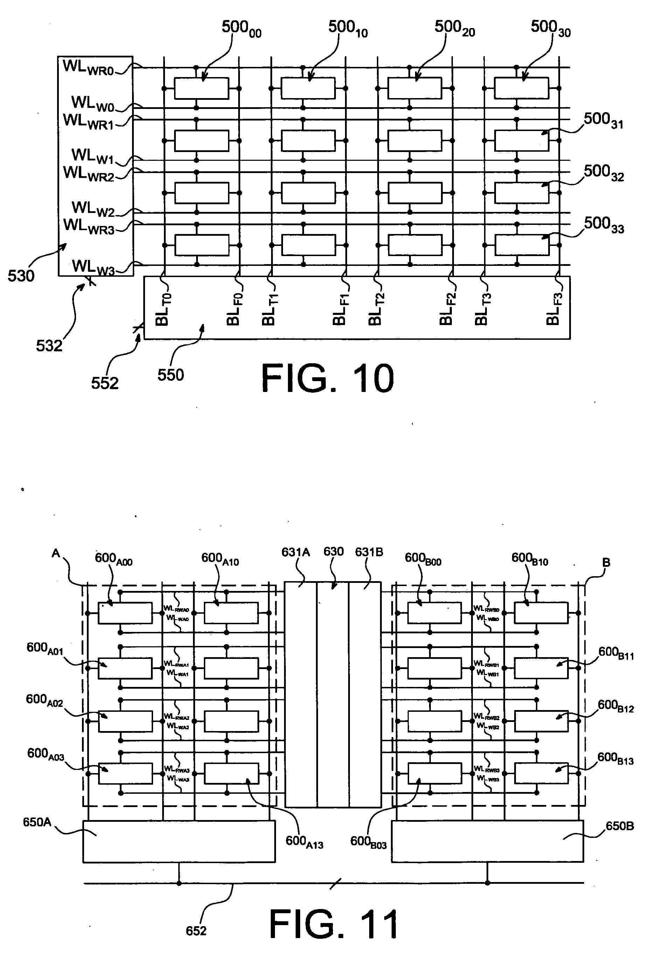

La figure 10 donne un autre exemple de plan mémoire non multiplexé, intégrant 4x4 cellules mémoires 500₀₀, 500₁₀, 500₂₀, 500₃₀, ..., 500₃₀, 500₃₁, 500₃₂, 500₃₃, à 2 lignes de mots, qui ne sont pas suivant l'invention et semblables à l'une ou l'autre des cellules 100, 300, ou 400, décrites précédemment. Chacune des colonnes de la matrice comprend deux lignes de bit BL_{T0}, BL_{F0} ,..., BL_{T3}, BL_{F3} est contrôlée par des moyens formant un décodeur de colonne 550 associés à un bus de données 552. Chacune des rangées de la matrice comprend deux lignes de mot WL_{WR0}, WL_{W0}, ..., WL_{WR3}, WL_{W3} et est contrôlée par un décodeur de ligne 530, associé à un bus d'adresses 532. Chaque rangée comprend une ligne de mot WL_{WR0}, ou WL_{WR1}, ou WL_{WR2}, ou WL_{WR3}, dédiée aux opérations de lecture et d'écriture, et susceptible d'être activée lors d'opérations de lecture ou d'écriture. Chaque rangée comprend également une ligne de mot WL_{W0}, ou WL_{W1}, ou WL_{W2}, ou WL_{W3}, dédiée aux opérations d'écriture et susceptible d'être activée uniquement lors d'opérations d'écriture.

Selon une variante, une matrice mémoire multiplexée, peut être mis en oeuvre, afin de minimiser le courant d'accès et d'améliorer le facteur de stabilité en lecture. Avec un tel agencement de matrice, on peut réduire le nombre de cellules auxquelles on appliquerait inutilement un potentiel de polarisation lors d'une opération d'écriture.

La matrice peut être divisée en plusieurs blocs d'adressage, par exemple en deux blocs A et B comme illustré sur la figure 11.

Une telle matrice intègre également des cellules mémoires 600_{A00}, 600_{B00},... , 600_{A13}, 600_{B13} à 2 lignes de mots, et semblables à l'une ou l'autre des cellules 100, 300 ou 400 décrites précédemment.

Les deux blocs comprennent respectivement, une première pluralité de paires de lignes de mots WL_{RWA0}, WL_{RWA0},..., WL_{RWA3}, WL_{WA3}, et une deuxième pluralité de paires de lignes de mots WL_{RWB0}, WL_{RWB0}, ..., WL_{RWB3}, WL_{WB3}.

Des moyens formant un décodeur de ligne 630 sont prévus. Ces moyens 630 comportent des moyens de sélection 631A d'un premier bloc A de cellules 600_{A00},..., 600_{A13}, et des moyens de sélection 631B d'un deuxième bloc B de cellules 600_{B00},..., 600_{B13}.

Chacune des colonnes de la matrice comprend deux lignes de bit et est contrôlée par des moyens formant un décodeur de colonne noté 650A pour le premier bloc A et noté 650B pour le deuxième bloc B, les moyens décodeurs 650A, et 650B, étant associés à un bus de données 652.

Chacune des rangées de la matrice comprend une paire de lignes de mot de la première pluralité de lignes WL_{RWA0}, WL_{RWA0, ...,} WL_{RWA3}, WL_{WA3} appartenant au premier bloc A et une paire lignes de mot de la deuxième pluralité de lignes WL_{RWB0}, WL_{RWB0},..., WL_{RWB3}, WL_{WB3} appartenant au deuxième bloc B. Les lignes de mot d'une rangée donnée, qui sont associées à un bloc donné, sont activées indépendamment des lignes de mot appartenant à la même rangée donnée, mais qui appartiennent à l'autre bloc.

Dans cet exemple, la matrice est mise en oeuvre de sorte que lorsqu'une opération d'écriture est effectuée sur une cellule donnée d'un des blocs, par exemple la cellule 600_{A00} du premier bloc A, les cellules situées sur la même rangée que la cellule donnée et appartenant à l'autre bloc B, par exemple les cellules 600_{B00}, 600_{B00} du deuxième bloc B situées sur la même rangée que la cellule donnée 600_{A00}, ne sont quant à elles pas activées.

Une cellule mémoire à accès aléatoire suivant l'invention est dotée de transistors à double-grille asymétrique. Des cellules avec des transistors d'accès double-grille asymétriques peuvent s'avérer avantageuses notamment pour des applications avec lesquelles il est préférable d'adopter un plan mémoire multiplexé.

Une double-grille asymétrique est formée de deux grilles distinctes dissymétriques par rapport au plan principal de la zone active semi-conductrice de part et d'autre de laquelle ces grilles sont disposées. La dissymétrie peut être géométrique, ou/et obtenue à l'aide de matériaux de grilles différents. Dans un transistor doté d'une double-grille asymétrique, le courant délivré entre le drain et la source du transistor est différent suivant que la première grille ou la deuxième grille est activée, même pour une polarisation identique. Une double-grille asymétrique peut être formée d'une première grille dite « grille supérieure » et d'une deuxième grille dite « grille inférieure », la grille « supérieure » étant définie comme celle des deux grilles permettant de générer le courant le plus élevé à polarisation identique.

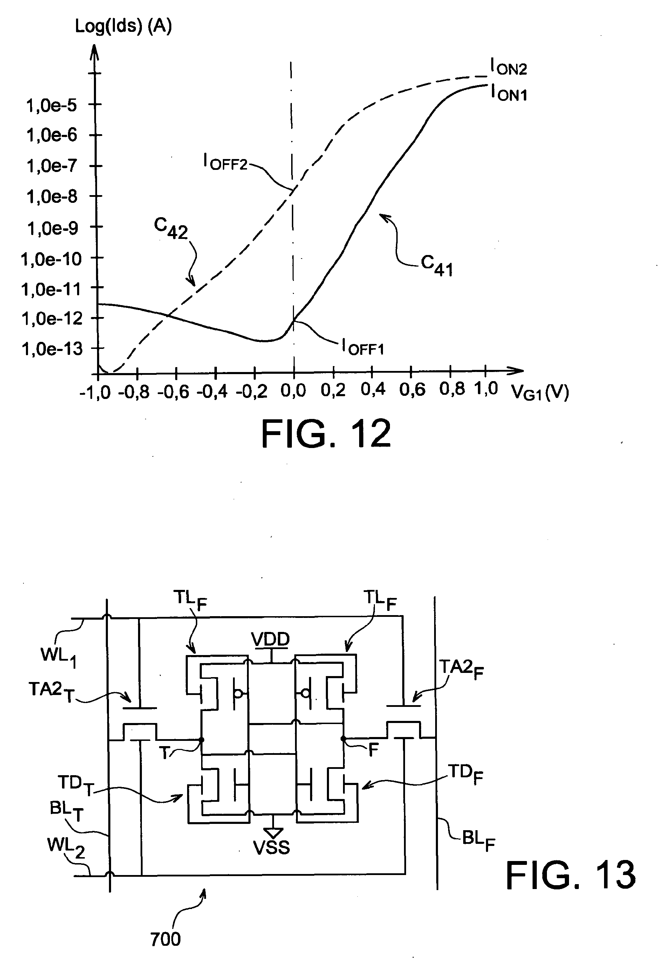

La figure 12 donne des caractéristiques électriques d'un exemple de transistor double-grille asymétrique susceptible d'être intégré dans une cellule mémoire suivant l'invention. Sur cette figure, des courbes C₄₁, C₄₂ sont représentatives, de l'évolution du courant traversant la zone active du transistor, entre son drain et sa source, en fonction d'un potentiel V_{G1} appliqué sur sa grille supérieure pour différents valeurs fixes d'un potentiel V_{G2} appliqué sur sa grille inférieure. La courbe C₄₁ est donnée pour une première valeur de potentiel V_{G2} qui, dans cet exemple, est de 0 volt, tandis que la courbe C₄₂ est donnée pour une deuxième valeur de potentiel V_{G2} qui, dans cet exemple, est de 1 volt. Cet exemple de transistor se caractérise par deux courants I_{ON1} et I_{ON2} à l'état passant pour un potentiel appliqué sur la première grille V_{G1}=VDD et un potentiel appliqué sur la deuxième grille V_{G1} tel que V_{G1}=V_{G2}=VDD et deux courants I_{OFF} à l'état bloqué pour V_{G1}= 0V suivant que V_{G2}=0V ou VDD.

Un autre exemple de cellule mémoire 700 à accès aléatoire suivant l'invention, est illustré sur la figure 13. Cette cellule mémoire 700 est une cellule 6T, dotée de 6 transistors réalisés en technologie double grille, qui diffère de la cellule 100 précédemment décrite en liaison avec la figure 3, en ce qu'elle comporte un premier transistor d'accès TA2_{T} à double grille asymétrique et un deuxième transistor d'accès TA2_{F} à double grille asymétrique.

La cellule 700 comporte une première ligne de mot WL₁ connectée à la grille supérieure des transistors d'accès TA2_{T} et TA2_{F}, et une deuxième ligne de mot WL₂, connectée à la grille inférieure des transistors d'accès TA2_{T} et TA2_{F}. La deuxième ligne de mot WL₂ peut être dédiée uniquement aux opérations d'écriture, et n'être activée que lors d'une opération d'écriture. En fonction dont la deuxième ligne de mot WL₂ est polarisée, le courant de fuite des transistors d'accès TA2_{T} et TA2_{F} est modulé entre deux seuils I_{OFF1} et I_{OFF2}.

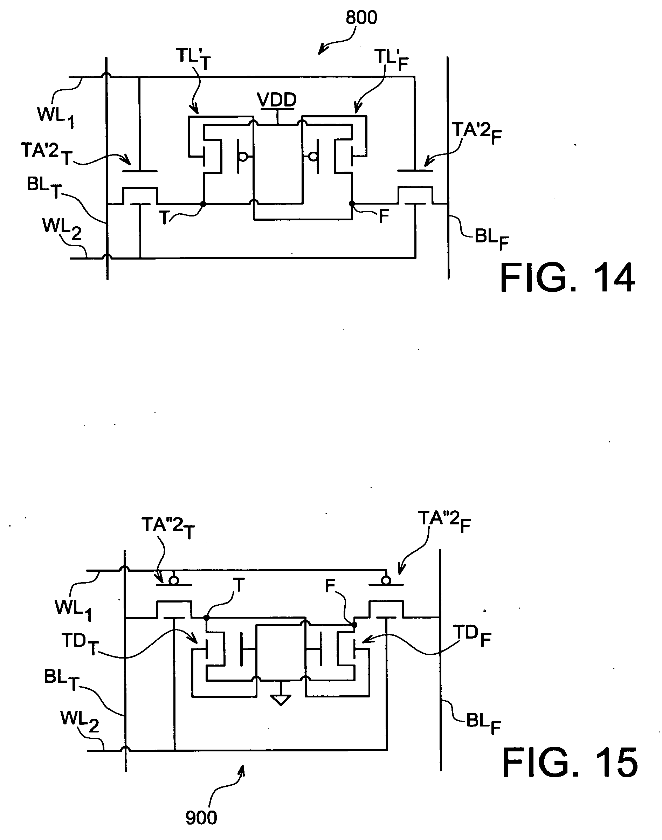

Un autre exemple de cellule mémoire 800 à accès aléatoire suivant l'invention, est illustré sur la figure 14.

Cette cellule mémoire 800 est une cellule 4T, dotée de 4 transistors réalisés en technologie double grille, qui diffère de la cellule 300 précédemment décrite en liaison avec la figure 6, en ce qu'elle comporte un premier transistor d'accès TA'2_{T} à double grille asymétrique et un deuxième transistor d'accès TA'2_{F} à double grille asymétrique.

Dans cet exemple, une ligne de mot WL₂, dédiée uniquement aux opérations d'écriture, peut être également connectée à la grille inférieure des transistors d'accès TA'2_{T} et TA'2_{F} tandis que l'autre ligne de mot WL₁, est connectée à la grille supérieure des transistors d'accès TA'2_{T} et TA'2_{F}.

Un autre exemple de cellule mémoire 900 à accès aléatoire suivant l'invention, est illustré sur la figure 15. Cette cellule mémoire 900 est une cellule 4T, dotée de 4 transistors réalisés en technologie double grille, qui diffère de la cellule 400 précédemment décrite en liaison avec la figure 8, en ce qu'elle comporte un premier transistor d'accès TA"2_{T} à double grille asymétrique et un deuxième transistor d'accès TA" 2_{F} à double grille asymétrique.

Les cellules 700, 800, 900 précédemment décrites, à deux lignes de mots et comportant des transistors d'accès à double grille asymétriques, peuvent être intégrées dans un plan ou une matrice mémoire multiplexée.

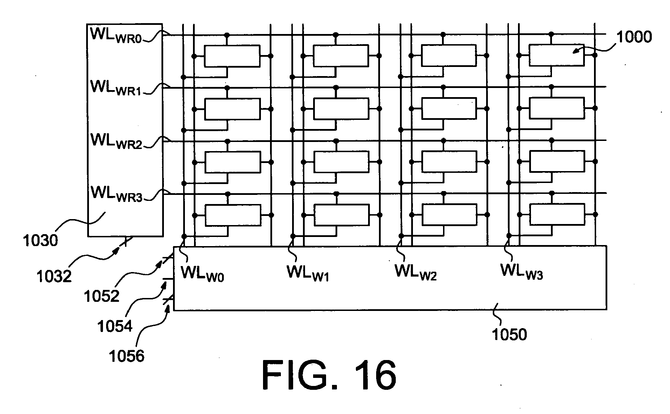

Un exemple d'une telle matrice, comportant des cellules 1000, du type des cellules 700, 800, 900, précédemment décrites, est illustré sur la figure 16.

Dans cet exemple, la matrice comporte des lignes de mots qui sont croisées. Une première pluralité de lignes de mots WL_{WR0},...,WL_{WR3} dédiées à la commande de lecture et d'écriture, est connectée à des moyens formant un décodeur de ligne 1030. Les lignes de mots WL_{WR0},...,WL_{WR3} de la première pluralité de lignes de mots WL_{WR0},...,WL_{WR3} sont reliées respectivement à des cellules d'une même rangée de la matrice.

Une deuxième pluralité de lignes de mots WL_{W0}, ..., WL_{W3}, orthogonales à celles de la première pluralité lignes de mots, est connectée à des moyens 1050 formant un décodeur de colonne. Les lignes de mots de la deuxième pluralité de lignes de mots WL_{W0},...,WL_{W3} sont dédiées à la commande d'écriture. Les lignes de mots WL_{W0},...,WL_{W3} de la deuxième pluralité de lignes de mots WL_{W0}, ..., WL_{W3} sont reliées respectivement à des cellules d'une même colonne de la matrice.

Les moyens formant un décodeur de ligne 1030 sont reliés à un bus d'adresse 1032. Les moyens formant un décodeur de colonne 1050 sont reliés quant à eux à un bus d'adresse 1052, un bus de données 1056. Un signal parvenant à une entrée 1056 du décodeur 1052, permet d'indiquer au décodeur 1050 la distinction entre un mode de lecture ou d'écriture.

Une opération d'écriture dans une cellule donnée peut être réalisée lorsqu'une première ligne de mot, reliée à ladite cellule donnée, et appartenant à la première pluralité de lignes de mots, et qu'une deuxième ligne de mot reliée à ladite cellule donnée et appartenant à ladite deuxième pluralité de lignes de mots, sont simultanément activées.

Dans ce cas, des cellules mémoires situées sur la même rangée que ladite cellule donnée, ne sont pas perturbées par l'activation de la première ligne de mots, tandis que des cellules mémoire situées sur la même colonne que la cellule donnée, ne sont pas perturbées par l'activation de la deuxième ligne de mots.

Selon une variante possible de mise en oeuvre des cellules précédemment décrites, tous les transistors des transistors des cellules à deux lignes de mots peuvent être dotés d'une double grille asymétrique.

### Documents cités

[1] : K. NODA, et al., « A 16-Mb 400-MHz loadless CMOS Four-Transistor SRAM Macro », IEEE JSSC, Vol.35, No.11, Novembre 2000.
[2] : N. AZIZI, et al., « Low-Leakage Asymetric-Cell SRAM », IEEE TVLSI, VOL.11, Issue 4, pp. 701-715, August 2003.
[3] : A. AGARWAL, et al., « DRG-Cache : A Data Retention Gated-Ground Cache for Low Power », DAC, pp. 473-478, June 2002.
[4] : K. FLAUNTER, et al., « Drowsy Caches: Simple Techniques for Reducing Leakage Power » ISCAS, Arizona, USA, May 2002.
[5] : K. OSADA, et al. « 16.7-fA/cell tunnel-leakage-suppressed 16-Mbit SRAM for handling cosmic-ray-induced multi-errors », IEEE HSSC, VOL.38, No.11, November 2003.
[6] _{:} K. Takeuchi, et al., « A Study of Threshold Voltage Variation for Ultra SmallBulk and SOI CMOS », IEEE TED, VOL.48, No.9, September 2004.
[7] : M. YAMAOKA, et al., « Low Power SRAM Menu for SOC Application Using Yin-Yang-Feedback memory Cell Technology », Symposium on VLSI circuits, Digest of Technical Papers, Honolulu, USA, June 2004.
[8] : E. SEEVINCK, et al., « Static-Noise Margin Analysis of MOS SRAM cells », IEEE JSSC, VOL. SC-22, No.5, October 1987.
[9] : A. CHANDRAKASAN, et al., « Design of High-Performance Microprocessor Circuits », IEEE press, pp.285-308, FOX 2001.
[10] : J. J. KIM, et al., « Back-Gate Controlled READ SRAM with Improved Stability », IEEE SOI CONFERENCE, pp. 211-212, Hawaii, USA, 2005
[11] : US 02T15 A1.
[12] : US 644060 B1.
[13] : EP 1 465 200 A1.
[14]: O. THOMAS, A. AMARA, « An SOI 4 Transistors Self-Refresh Ultra-Low-Voltage memory cell », ISCAS, Thailand, Bangkok, May 2003.

## Revendications

1. Cellule de mémoire vive à accès aléatoire, comprenant :
- une première pluralité de transistors (TL_{T}, TL_{F}, TD_{T}, TD_{F}, TL'_{T}, TL'_{F}, TD"_{T}, TD"_{F}) double grille,
- un premier transistor d'accès (TA_{T}, TA'_{T}, TA"_{T}) à double grille et un second transistor d' accès (TA_{F}, TA'_{F}, TA"_{F}, TA2_{F}, TA'2_{F}, TA"2_{F}) à double grille disposés respectivement entre une première ligne de bit (BL_{T}) et un premier noeud de stockage (T), et entre une deuxième ligne de bit (BLF) et un deuxième noeud de stockage (F), une première grille du premier transistor d' accès (TA_{T}, TA'_{T}, TA"_{T}, TA2_{T}, TA'2_{T}, TA"2_{T}) et une première grille du deuxième transistor d'accès (TA_{F}, TA'_{F}, TA"_{F}, TA2_{F}, TA'2_{F}, TA"2_{F}) étant reliées à une première ligne de mot (WL₁) apte à acheminer un signal de polarisation, une seconde grille du premier transistor d'accès et une seconde grille du deuxième transistor d'accès étant reliées à une deuxième ligne de mot (WL₂) apte à acheminer un autre signal de polarisation, la cellule étant **caractérisée en ce que** le premier transistor d' accès (TA2_{T}, TA'2_{T}, TA"2_{T}) et le deuxième transistor d' accès (TA2_{F}, TA'2_{F}, TA"2_{F}) sont des transistors à double-grille asymétrique.

2. Cellule de mémoire vive à accès aléatoire (RAM), selon la revendication 1, ladite première pluralité de transistors étant formée :
- d'un premier transistor de charge (TL_{T}) à double grille et d'un deuxième transistor de charge (TL_{F}) à double grille, les deux grilles du premier transistor de charge (TL_{T}) étant connectées ensemble, les deux grilles du deuxième transistor de charge (TL_{F}) étant également connectées ensemble,
- d'un premier transistor de conduction (TD_{T}) à double grille, et d'un deuxième transistor de conduction (TD_{F}) à double grille, les deux grilles du premier transistor de conduction (TD_{T}) étant connectées ensemble, les deux grilles du deuxième transistor de conduction (TD_{F}) étant également connectées ensemble.

3. Cellule de mémoire vive à accès aléatoire (RAM), selon la revendication 1, ladite pluralité de transistors étant formée :
- d'un premier transistor de charge (TL'_{T}) à double grille et d'un deuxième transistor de charge (TL'_{F}) à double grille, les deux grilles du premier transistor de charge (TL'_{T}) étant connectées ensemble, les deux grilles du deuxième transistor de charge (TL'_{F}) étant également connectées ensemble,
- ou d'un premier transistor de conduction (TD"_{T}) à double grille, et d'un deuxième transistor de conduction (TD"_{F}) à double grille, les deux grilles de chacun des transistors de conduction (TD"_{F}) étant connectées ensemble, les deux grilles du premier transistor de conduction (TD"_{T}) étant connectées ensemble, les deux grilles du deuxième transistor de conduction (TD"_{F}) étant également connectées ensemble.

4. Cellule de mémoire vive à accès aléatoire (RAM), selon l'une des revendications 1 à 3, susceptible d'adopter un mode de rétention dans lequel la première ligne de mot (WL1) et la deuxième ligne de mot (WL2) sont respectivement à un premier potentiel dit « de rétention» et à un deuxième potentiel dit « de rétention », le premier potentiel de rétention et le deuxième potentiel de rétention étant prévus pour bloquer le premier transistor d'accès et le deuxième transistor d'accès.

5. Cellule de mémoire vive à accès aléatoire (RAM) selon la revendication 4, le premier potentiel de rétention et le deuxième potentiel de rétention étant égaux.

6. Cellule de mémoire vive à accès aléatoire (RAM), selon l'une des revendications 1 à 5, susceptible d'adopter un mode d'écriture dans lequel la première ligne de mot (WL1) et la deuxième ligne de mot (WL2) sont respectivement à un premier potentiel dit « d'écriture » et à un deuxième potentiel dit « d'écriture », le premier potentiel d'écriture et le deuxième potentiel d'écriture étant prévus pour rendre passant ou saturer, le premier transistor d'accès et le deuxième transistor d'accès.

7. Cellule de mémoire vive à accès aléatoire (RAM), selon la revendication 6, le premier potentiel d'écriture et le deuxième potentiel d'écriture étant égaux.

8. Cellule de mémoire vive à accès aléatoire (RAM), selon la revendication 6 ou 7, susceptible d'adopter un mode de lecture dans lequel la première ligne de mot (WL1) et la deuxième ligne de mot (WL2) sont respectivement à un premier potentiel dit « de lecture » et à un deuxième potentiel dit « de lecture », le premier potentiel de lecture et le deuxième potentiel de lecture étant différents.

9. Cellule de mémoire vive à accès aléatoire (RAM), selon la revendication 8, le premier potentiel de lecture et le deuxième potentiel de lecture étant inférieurs respectivement, au premier potentiel d'écriture et au deuxième potentiel d'écriture.

10. Cellule de mémoire vive à accès aléatoire (RAM), selon l'une des revendications 1 à 9, dans laquelle le premier transistor d'accès et le deuxième transistor d'accès à double-grille asymétrique comportent respectivement une grille supérieure et une grille inférieure, et dans laquelle la deuxième ligne de mot (WL₂) est uniquement dédiée aux opérations d'écriture dans la cellule, la deuxième ligne de mot étant connectée à la grille inférieure des transistors d'accès.

11. Dispositif microélectronique de mémoire vive à accès aléatoire (RAM), comprenant une pluralité de cellules (100, 300, 400, 500, 600, 700, 800, 1000) suivant l'une des revendications 1 à 10.

12. Dispositif microélectronique de mémoire vive à accès aléatoire (RAM), suivant la revendication 11, dans lequel les cellules sont agencées en une matrice divisée en au moins un premier bloc (A) comprenant une première pluralité de lignes de mots (WL_{RWA0}, WL_{RWA0},..., WL_{RWA3}, WL_{WA3}), et au moins un deuxième bloc (B) comprenant une deuxième pluralité de lignes de mots (WL_{RWB0}, WL_{RWB0},..., WL_{RWB3}, WL_{WB3}), le dispositif comprenant en outre :
- des moyens de sélection (631A, 631B) de bloc de cellules,
- des moyens d'activation de lignes mots, aptes à activer une ou plusieurs lignes de mots d'un bloc, indépendamment des lignes de mots de l'autre bloc.

13. Dispositif microélectronique de mémoire vive à accès aléatoire (RAM), suivant la revendication 12, dans lequel les cellules sont agencées selon une matrice, le dispositif comprenant en outre :
- des moyens formant un premier décodeur, de lignes ou de colonnes, connecté à une première pluralité de lignes de mots dédiées à des opérations de lecture et d'écriture,
- des moyens formant un deuxième décodeur, de colonnes ou de lignes connecté à une deuxième pluralité de lignes de mots dédiées aux opérations d'écriture.

## Claims

1. Random access memory cell comprising:
- a first plurality of double gate transistors (TL_{T}, TL_{F}, TD_{T}, TD_{F}, TL'_{T}, TL'_{F}, TD"_{T}, TD"_{F}),
- a first double gate access transistor (TA_{T}, TA'_{T}, TA"_{T}) and a second double gate access transistor (TA_{F}, TA'_{F}, TA"_{F}) arranged between a first bit line (BL_{T}) and a first storage node (T), and between a second bit line (BLF) and a second storage node (F) respectively, a first gate of the first access transistor (TA_{T}, TA'_{T}, TA"_{T}, TA2_{T}, TA'2_{T}, TA"2_{T}) and a first gate of the second access transistor (TA_{F}, TA'_{F}, TA"_{F}, TA2_{F}, TA'2_{F}, TA"2_{F}) being connected to a first word line (WL₁) capable of carrying a bias signal, a second gate of the first access transistor (TA_{T}, TA'_{T}, TA"_{T}, TA2_{T}, TA'2_{T}, TA"2_{T}) and a second gate of the second access transistor (TA_{F}, TA'_{F}, TA"_{F}, TA2_{F}, TA'2_{F}, TA"2_{F}) being connected to a second word line (WL₂) capable of carrying another bias signal, the cell being **characterized in that** the first access transistor (TA2_{T}, TA'2_{T}, TA"2_{T}) and the second access transistor (TA2_{F}, TA'2_{F}, TA"2_{F}) are asymmetrical double gate transistors.

2. Random access memory (RAM) cell, as claimed in claim 1, said first plurality of transistors being formed from:
- a first double gate load transistor (TL_{T}) and a second double gate load transistor (TL_{F}) the two gates of the first load transistor being connected to each other, and the two gates of the second load transistor also connected to each other,
- a first double gate conduction transistor (TD_{T}) and a second double gate conduction transistor (TD_{F}) the two gates of the first conduction transistor being connected to each other, the two gates of the second conduction transistor also being connected to each other.

3. Random access memory cell, as claimed in claim 1, said plurality of transistors being formed from:
- a first double gate load transistor (TL'_{T}) and a second double gate load transistor (TL'_{F}), the two gates of the first load transistor being connected to each other and the two gates of the second load transistor also being connected to each other,
- or a first double gate conduction transistor (TD"_{T}) and a second double gate conduction transistor (TD"_{F}), the two gates of each of the conduction transistors being connected to each other, the two gates of the first conduction transistor being connected to each other, the two gates of the second conduction transistor also being connected to each other.

4. Random access memory cell, as claimed in any of claims 1 to 3, that may adopt a retention mode in which the first word line (WL1) and the second word line (WL2) are connected respectively to a first so-called « retention » potential and a second so-called « retention » potential respectively, the first retention potential and the second retention potential being designed to block the first access transistor and the second access transistor.

5. Random access memory (RAM) cell as claimed in claim 4, the first retention potential and the second retention potential being equal.

6. Random access memory (RAM) cell, as claimed in any of claims 1 to 5, that can be used in a write mode in which the first word line (WL1) and the second word line (WL2) are at a first so-called « write » potential and a second so-called « write » potential respectively, the first write potential and the second write potential being designed to make the first access transistor and the second access transistor conducting or saturated.

7. Random access memory (RAM) cell, as claimed in claim 6, the first write potential and the second write potential being equal.

8. Random access memory (RAM) cell, as claimed in either claim 6 or 7, that can adopt a read mode in which the first word line (WL1) and the second word line (WL2) are equal to a first so-called « read » potential and a second so-called « read » potential respectively, the first read potential and the second read potential being different.

9. Random access memory (RAM) cell, as claimed in claim 8, the first read potential and the second read potential being less than the first write potential and the second write potential respectively.

10. Random access memory (RAM), as claimed in any of claims 1 to 9, in which the first access transistor and the second access transistor with asymmetric double-gate comprise an upper gate and a lower gate respectively, and in which said second word line (WL₂) is dedicated solely to write operations into the cell, the second word line being connected to the lower gate of the access transistors.

11. Microelectronic device with a random access memory (RAM), comprising a plurality of cells (100,300,400,500,600,700,800,1000) as claimed in one of claims 1 to 10.

12. Microelectronic device with a random access memory (RAM), as claimed in claim 11, in which the cells are arranged in a matrix divided into at least a first block (A) comprising a plurality of word lines (WL_{RWA0}, WL_{RWA0,...}, WL_{RWA3}, WL_{WA3}), and at least a second block (B) comprising a plurality of word lines (WL_{RWB0}, WL_{RWB0,...}, WL_{RWB3}, WL_{WB3}), the device also comprising :
- means for selecting a block of cells (631A, 631B),
- means for activating word lines, capable of activating one or several word lines in a block, independently of word lines in the other block.

13. Microelectronic device with a random access memory (RAM) as claimed in claim 12, in which the cells are arranged as a matrix, the device also comprising:
- means forming a first line or column decoder, connected to a first plurality of word lines dedicated to read and write operations,
- means forming a second column or line decoder connected to a second plurality of word lines dedicated to write operations.

## Patentansprüche

1. Zelle für einen Arbeitsspeicher mit wahlfreiem Zugriff, umfassend:
- eine erste Mehrzahl von Transistoren (TL_{T}, TL_{F}, TD_{T}, TD_{F}, TL'_{T}, TL'_{F}, TD"_{T}, TD"_{F}) mit Doppel-Gatter,
- einen ersten Zugangstransistor (TA_{T}, TA'_{T}, TA"_{T}) mit Doppel-Gatter und einen zweiten Zugangstransistor (TA_{F}, TA'_{F}, TA"_{F}, TA2_{F}, TA'2_{F}, TA"2_{F}) mit Doppel-Gatter, die jeweils zwischen einer ersten Bit-Leitung (BL_{T}) und einem ersten Speicherknoten (T) bzw. zwischen einer zweiten Bit-Leitung (BL_{F}) und einem zweiten Speicherknoten (F) angeordnet sind, wobei ein erstes Gatter von dem ersten Zugangstransistor (TA_{T}, TA'_{T}, TA"_{T}, TA2_{T}, TA'2_{T}, TA"2_{T}) und ein erstes Gatter von dem zweiten Zugangstransistor (TA_{F}, TA'_{F}, TA"_{F}, TA2_{F}, TA'2_{F}, TA"2_{F}) mit einer ersten Wort-Leitung (WL₁) verbunden sind, die dazu geeignet ist, ein Polarisationssignal zu befördern, wobei ein zweites Gatter von dem ersten Zugangstransistor und ein zweites Gatter von dem zweiten Zugangstransistor mit einer zweiten Wortleitung (WL₂) verbunden sind, die dazu geeignet ist, ein anderes Polarisationssignal zu befördern, wobei die Zelle **dadurch gekennzeichnet ist, dass** der erste Zugangstransistor (TA2_{T}, TA'2_{T}, TA"2_{T}) und der zweite Zugangstransistor (TA2_{F}, TA'2_{F}, TA"2_{F}) Transistoren mit asymmetrischem Doppel-Gatter sind.

2. Zelle für einen Arbeitsspeicher mit wahlfreiem Zugriff (RAM) nach Anspruch 1, wobei die erste Mehrzahl von Transistoren gebildet ist aus:
- einem ersten Ladungstransistor (TL_{T}) mit Doppel-Gatter und einem zweiten Ladungstransistor (TL_{F}) mit Doppel-Gatter, wobei die zwei Gatter von dem ersten Ladungstransistor (TL_{T}) miteinander verbunden sind, wobei die zwei Gatter von dem zweiten Ladungstransistor (TL_{F}) ebenfalls miteinander verbunden sind,
- einem ersten Leitungstransistor (TD_{T}) mit Doppel-Gatter und einem zweiten Leitungstransistor (TD_{F}) mit Doppel-Gatter, wobei die zwei Gatter von dem ersten Leitungstransistor (TD_{T}) miteinander verbunden sind, wobei die zwei Gatter von dem zweiten Leitungstransistor (TD_{F}) ebenfalls miteinander verbunden sind.

3. Zelle für einen Arbeitsspeicher mit wahlfreiem Zugriff (RAM) nach Anspruch 1, wobei die Mehrzahl der Transistoren gebildet ist aus:
- einem ersten Ladungstransistor (TL'_{T}) mit Doppel-Gatter und einem zweiten Ladungstransistor (TL'_{F}) mit Doppel-Gatter, wobei die zwei Gatter von dem ersten Ladungstransistor (TL'_{T}) miteinander verbunden sind, wobei die zwei Gatter von dem zweiten Ladungstransistor (TL'_{F}) ebenfalls miteinander verbunden sind,
- oder einem ersten Leitungstransistor (TD"_{T}) mit Doppel-Gatter und einem zweiten Leitungstransistor (TD"_{F}) mit Doppel-Gatter, wobei die zwei Gatter von jedem der Leitungstransistoren (TD"_{F}) miteinander verbunden sind, wobei die zwei Gatter von dem ersten Leitungstransistor (TD"_{T}) miteinander verbunden sind, wobei die zwei Gatter von dem zweiten Leitungstransistor (TD"_{F}) ebenfalls miteinander verbunden sind.

4. Zelle für einen Arbeitsspeicher mit wahlfreiem Zugriff (RAM) nach einem der Ansprüche 1 bis 3, die dazu geeignet ist, einen Haltemodus anzunehmen, in welchem sich die erste Wortleitung (WL1) und die zweite Wortleitung (WL2) bei einem ersten als "Haltepotenzial" bezeichneten Potenzial bzw. einem zweiten als "Haltepotenzial" bezeichneten Potenzial befinden, wobei das erste Haltepotenzial und das zweite Haltepotenzial vorgesehen sind, um den ersten Zugangstransistor und den zweiten Zugangstransistor zu sperren.

5. Zelle für einen Arbeitsspeicher mit wahlfreiem Zugriff (RAM) nach Anspruch 4, wobei das erste Haltepotenzial und das zweite Haltepotenzial gleich sind.

6. Zelle für einen Arbeitsspeicher mit wahlfreiem Zugriff (RAM) nach einem der Ansprüche 1 bis 5, die dazu geeignet ist, einen Schreibmodus anzunehmen, in welchem sich die erste Wortleitung (WL1) und die zweite Wortleitung (WL2) bei einem ersten als "Schreibpotenzial" bezeichneten Potenzial bzw. bei einem zweiten als "Schreibpotenzial" bezeichneten Potenzial befinden, wobei das erste Schreibpotenzial und das zweite Schreibpotenzial vorgesehen sind, um den ersten Zugangstransistor und den zweiten Zugangstransistor durchlässig zu machen oder zu sättigen.

7. Zelle für einen Arbeitsspeicher mit wahlfreiem Zugriff (RAM) nach Anspruch 6, wobei das erste Schreibpotenzial und das zweite Schreibpotenzial gleich sind.

8. Zelle für einen Arbeitsspeicher mit wahlfreiem Zugriff (RAM) nach Anspruch 6 oder 7, die dazu geeignet ist, einen Lesemodus anzunehmen, in welchem die erste Wortleitung (WL1) und die zweite Wortleitung (WL2) sich bei einem ersten als "Lesepotenzial" bezeichneten Potenzial bzw. bei einem zweiten als "Lesepotenzial" bezeichneten Potenzial befinden, wobei das erste Lesepotenzial und das zweite Lesepotenzial unterschiedlich sind.

9. Zelle für einen Arbeitsspeicher mit wahlfreiem Zugriff (RAM) nach Anspruch 8, wobei das erste Lesepotenzial und das zweite Lesepotenzial jeweils kleiner als das erste Schreibpotenzial und das zweite Schreibpotenzial sind.

10. Zelle für einen Arbeitsspeicher mit wahlfreiem Zugriff (RAM) nach einem der Ansprüche 1 bis 9, wobei der erste Zugangstransistor und der zweite Zugangstransistor mit asymmetrischem Doppel-Gatter jeweils ein höheres Gatter und ein niedrigeres Gatter umfassen, und wobei die zweite Wortleitung (WL₂) nur Schreiboperationen in der Zelle gewidmet ist, wobei die zweite Wortleitung mit dem niedrigeren Gatter der Zugangstransistoren verbunden ist.

11. Mikroelektronik-Einrichtung mit Arbeitsspeicher mit wahlfreiem Zugriff (RAM), umfassend eine Mehrzahl von Zellen (100, 300, 400, 500, 600, 700, 800, 1000) gemäß einem der Ansprüche 1 bis 10.

12. Mikroelektronik-Einrichtung mit Arbeitsspeicher mit wahlfreiem Zugriff (RAM) gemäß Anspruch 11, wobei die Zellen in einer Matrix angeordnet sind, die unterteilt ist in wenigstens einen ersten Block (A), der eine erste Mehrzahl von Wortleitungen (WL_{RWA0}, WL_{RWA0,...}, WL_{RWA3}, WL_{WA3}) umfasst, und wenigstens einen zweiten Block (B), der eine zweite Mehrzahl von Wortleitungen (WL_{RWB0}, WL_{RWB0,...}, WL_{RWB3}, WL_{WB3}) umfasst, wobei die Einrichtung weiterhin umfasst:
- Auswahlmittel (631A, 631 B) für Zellenblöcke,
- Aktivierungsmittel für Wortleitungen, die dazu geeignet sind, eine oder mehrere Wortleitungen von einem Block zu aktivieren, unabhängig von den Wortleitungen von dem anderen Block.

13. Mikroelektronik-Einrichtung mit Arbeitsspeicher mit wahlfreiem Zugriff (RAM) gemäß Anspruch 12, wobei die Zellen in einer Matrix angeordnet sind, wobei die Einrichtung weiterhin umfasst:
- Mittel, welche einen ersten Decoder bilden, aus Zeilen oder Spalten, verbunden mit einer ersten Mehrzahl von Wortleitungen, die Lese- und Schreiboperationen gewidmet sind,
- Mittel, welche einen zweiten Decoder bilden, aus Spalten oder Zeilen, verbunden mit einer zweiten Mehrzahl von Wortleitungen, welche Schreiboperationen gewidmet sind.
